(19) **Europäisches Patentamt**
**European Patent Office**
**Office européen des brevets**

(11) **EP 1 667 173 B1**

(12) **EUROPEAN PATENT SPECIFICATION**

(45) Date of publication and mention
of the grant of the patent:
**04.09.2013 Bulletin 2013/36**

(51) Int Cl.:
*H01B 13/00* (2006.01)    *H01L 39/24* (2006.01)

(21) Application number: **04771090.0**

(22) Date of filing: **30.07.2004**

(86) International application number:
**PCT/JP2004/010930**

(87) International publication number:
**WO 2005/029511 (31.03.2005 Gazette 2005/13)**

(54) **Method of suppressing ballooning of an oxide superconducting wire upon temperature increase**

Verfahren zur Vermeidung von Aufblähen eines Oxidsupraleiterdrahtes beim Aufwärmen

Procédé pour supprimer le ballonnement d'un fil d'oxyde supraconducteur lors d'une augmentation de température

(84) Designated Contracting States:
**DE FR GB IT**

(30) Priority: **17.09.2003  JP 2003324493**

(43) Date of publication of application:
**07.06.2006  Bulletin 2006/23**

(73) Proprietor: **Sumitomo Electric Industries, Ltd.**
**Osaka-shi, Osaka 541-0041 (JP)**

(72) Inventors:
• **KATO, Takeshi,**
**Osaka-shi,**
**Osaka 5548511 (JP)**
• **KOBAYASHI, Shinichi,**
**Osaka-shi,**
**Osaka 5548511 (JP)**
• **YAMAZAKI, Kouhei,**
**Osaka-shi,**
**Osaka 5548511 (JP)**
• **OHKURA, Kengo,**
**Osaka-shi,**
**Osaka 5548511 (JP)**

(74) Representative: **Kreutzer, Ulrich**
**Cabinet Beau de Loménie**
**Lessingstrasse 6**
**80336 München (DE)**

(56) References cited:
**EP-A- 1 659 595        WO-A-03/100795**
**JP-A- 01 175 124       JP-A- 02 009 744**
**JP-A- 2002 175 732    JP-A- 2002 260 458**

• YUAN Y ET AL: "Microstructure and Jc Improvements in Overpressure Processed Ag-Sheathed Bi-2223 Tapes" IEEE TRANSACTIONS ON APPLIED SUPERCONDUCTIVITY, IEEE SERVICE CENTER, LOS ALAMITOS, CA, US, vol. 13, no. 2, 1 June 2003 (2003-06-01), pages 2921-2925, XP011098145 ISSN: 1051-8223
• HONJO S ET AL: "Electric Properties of a 66 kV 3-Core Superconducting Power Cable System" IEEE TRANSACTIONS ON APPLIED SUPERCONDUCTIVITY, IEEE SERVICE CENTER, LOS ALAMITOS, CA, US, vol. 13, no. 2, 1 June 2003 (2003-06-01), pages 1952-1955, XP011098344 ISSN: 1051-8223

EP 1 667 173 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Technical Field

The present invention relates to a method of suppressing ballooning also upon temperature increase without temperature control.

Background Art

When a superconducting device such as a superconducting cable is used, the superconducting device is dipped in a liquid refrigerant such as liquid nitrogen or liquid helium, for example, and held at a cryogenic temperature for cooling a superconductor filament in the superconducting device to below the critical temperature ($T_c$). On the other hand, the superconducting device is taken out from the liquid refrigerant at the time of inspection or the like, for example, and a gas refrigerant or the like of the room temperature is fed around the superconducting device for heating the device from the cryogenic temperature to the room temperature. When the device is heated to the room temperature after the same is dipped in the liquid refrigerant, however, the following problem arises in the conventional superconducting device.

Small pinholes are generally present on the surface of an oxide superconducting wire constituting the superconducting device. When this oxide superconducting wire is dipped in the refrigerant over a long period, the liquid refrigerant infiltrates into gaps of the superconductor filament in the oxide superconducting wire through the pinholes. When the temperature is increased to the normal temperature from this state, the liquid refrigerant infiltrating into the oxide superconducting wire is vaporized and the vaporized gas is not discharged if the rate of temperature increase is excessive. Thus, the internal pressure of the oxide superconducting wire is increased to expand the oxide superconducting wire (resulting in ballooning). When ballooning takes place, the superconductor filament is disadvantageously broken to result in characteristic reduction such as reduction of the critical current density.

In this relation, Japanese Patent Laying-Open No. 2002-260458 (Patent Literature 1), for example, discloses a vaporization rate control method of inhibiting a superconducting cable from ballooning. The vaporization rate control method disclosed in the aforementioned gazette is a method of controlling the vaporization rate of a refrigerant by setting the rate of temperature increase for a superconductor of the superconducting cable to not more than 10 K/hour. More specifically, the vaporization rate of the refrigerant is controlled by setting the rate of temperature increase for the superconductor of the superconducting cable to not more than 10 K/hour through means for supplying the refrigerant flowing into the superconducting cable at a temperature higher than that in ordinary cooling, means for supplying the refrigerant flowing into the superconducting cable at a flow rate smaller than that in ordinary cooling, means for introducing a temperature-increasing fluid of a temperature exceeding that of the refrigerant in ordinary cooling into the refrigerant fed to the superconducting cable or means for supplying the refrigerant to the superconducting cable while gradually increasing the pressure of the refrigerant from a state where the temperature of the refrigerant is not more than and close to the boiling point. Thus, the vaporization rate of the liquid refrigerant infiltrating into the superconducting wire is so relatively reduced that expansion of the wire can be suppressed.

Patent Literature 1: Japanese Patent Laying-Open No. 2002-260458

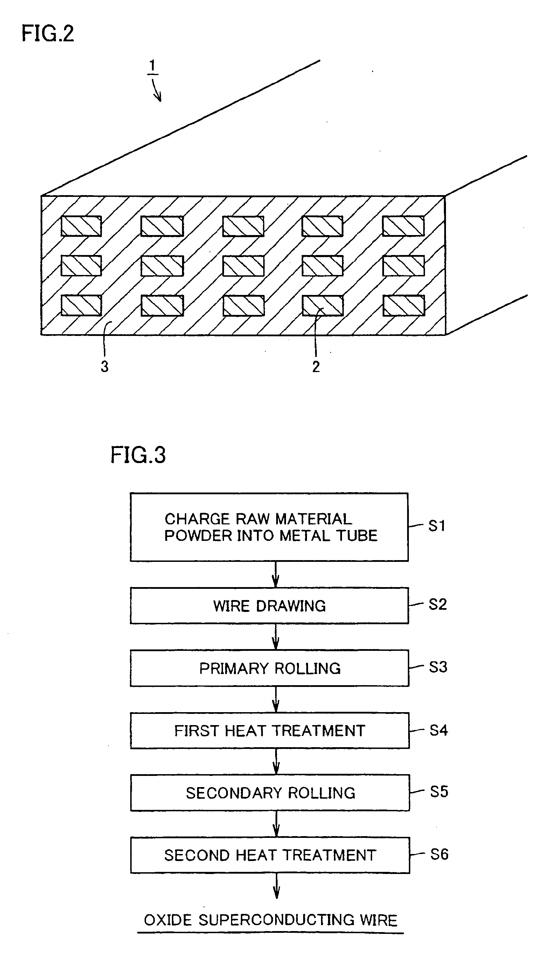

EP 1 659 595 A1 is a state of the art under Art. 54 (3) EPC and shows the method of Fig. 3 presented hereinafter with aspects of Figs. 2 - 8 and 10 - 18 presented hereinafter.

Y. Yuan et al., "Microstructure and Jc Improvements in Overpressure Processed Ag-Sheathed Bi-2223 Tapes", IEEE Transactions on applied superconductivity, Vol. 13, No.2, June 2003, pp. 2921-2925, teaches an oxide superconductor processing with a first atmospheric pressure heat treatment followed by intermediate rolling and pressurized heat treatment with optimized oxygen partial pressures.

EP 1 096 580 A1 shows an oxide superconducting wire which includes oxide superconducting filaments, a matrix, a covering layer and in insulating layer, the matrix being placed so as to enclose the oxide superconducting filaments and made of silver, the covering layer being placed so as to enclose the matrix and the insulating layer being placed so as to enclose the covering layer.

Problems to be Solved by the Invention

In the method disclosed in the aforementioned gazette, however, the rate for heating the superconductor from the cryogenic temperature to the room temperature must be controlled, and temperature control in temperature increase is complicated. Further, the rate of temperature increase for the superconductor is at such a small level of not more than 10 K/hour that a long time is required for increasing the temperature.

The following method is also conceivable as a method capable of suppressing ballooning following temperature increase without temperature control. In other words, a method of suppressing ballooning by plating the periphery of a sheath of an oxide superconducting wire constituting a superconducting device with a metal for blocking pinholes thereby inhibiting a liquid refrigerant from infiltrating into gaps of a superconductor filament in the oxide superconducting wire is also conceivable.

According to this method, however, the weight of the superconducting device is increased by the plated metal, to increase the size of the superconducting device. Further, the number of manufacturing steps for the superconducting device is also increased.

Accordingly, an object of the present invention is to suppress ballooning upon temperature increase without temperature control.

The invention concerns a method of suppressing ballooning of an oxide superconducting wire upon a temperature increase and is defined in the claims.

The method can be applied to the superconducting devices and wires as embodied in the following description.

Means

The superconducting device according to the present description has an oxide superconducting wire. The sintering density of an oxide superconductor in the oxide superconducting wire is at least 93 %.

The superconducting cable according to the present description has an oxide superconducting wire. The sintering density of an oxide superconductor in the oxide superconducting wire is at least 93 %.

According to each of the superconducting device and the superconducting cable, the number of gaps in the oxide superconductor is so extremely small that a liquid refrigerant hardly infiltrates into the gaps of the oxide superconductor. When the temperature is increased from a state dipped in the liquid refrigerant to the ordinary temperature without temperature control, therefore, the quantity of vaporized liquid refrigerant is extremely small. Consequently, the internal pressure of the oxide superconducting wire is hardly increased and ballooning can be suppressed.

Preferably in the superconducting device, the sintering density of the oxide superconductor in the oxide superconducting wire is at least 95 %.

Preferably, in the superconducting cable, the sintering density of the oxide superconductor in the oxide superconducting wire is at least 95 %.

Thus, the number of gaps in the oxide superconductor is so extremely reduced that the liquid refrigerant more hardly infiltrates into the gaps of the oxide superconductor. When the temperature is increased from a state dipped in the liquid refrigerant to the ordinary temperature without temperature control, therefore, ballooning can be more suppressed.

Preferably in the superconducting device, the sintering density of the oxide superconductor in the oxide superconducting wire is at least 99 %.

Preferably in the superconducting cable, the sintering density of the oxide superconductor in the oxide superconducting wire is at least 99 %.

Thus, the number of gaps in the oxide superconductor is so extremely reduced that the liquid refrigerant further hardly infiltrates into the gaps of the oxide superconductor. When the temperature is increased from a state dipped in the liquid refrigerant to the ordinary temperature without temperature control, therefore, ballooning can be further suppressed.

The oxide superconducting wire having the oxide superconductor exhibiting the aforementioned sintering density can be manufactured by the following manufacturing method:

A wire having a configuration obtained by covering raw material powder for the oxide superconductor with a metal is prepared. The wire is heat-treated in a pressurized atmosphere. The total pressure of the pressurized atmosphere is at least 1 MPa and less than 50 MPa.

According to the method of manufacturing an oxide superconducting wire, plastic flow and creep deformation of superconducting crystals formed in the heat treatment result from the large external pressure of at least 1 MPa for the wire, whereby the number of gaps between the oxide superconducting crystals is reduced (sintering density of the oxide superconductor is improved). Further, gas in gaps of oxide superconducting crystal powder formed in the heat treatment or gas adhering to the oxide superconducting crystal powder formed in the heat treatment can be inhibited from expansion in the heat treatment due to a pressure from outside a metal tube, whereby the oxide superconducting wire is inhibited from blistering. Consequently, the critical current density is improved.

In order to form a stable oxide superconducting phase, the partial oxygen pressure must be regularly controlled in a constant range regardless of the value of the total pressure in the pressurized atmosphere. If the total pressure in the pressurized atmosphere exceeds 50 MPa in this case, however, the partial oxygen pressure with respect to the total pressure is reduced. Thus, the value of the oxygen concentration in the pressurized atmosphere is so extremely reduced that the same is strongly influenced by a measurement error or the like, and hence the partial oxygen pressure is disadvantageously hard to control. According to the method of manufacturing an oxide superconducting wire, the heat treatment is performed in the pressurized atmosphere of less than 50 MPa, whereby the partial oxygen pressure with respect to the total pressure in the pressurized atmosphere is not excessively reduced but the oxygen concentration in the pressurized atmosphere is at a somewhat high level, whereby the partial oxygen pressure is easily controlled with no significant influence by the measurement error or the like. An oxide superconducting wire having an oxide superconductor exhibiting a sintering density of at least about 93 % and not more than about 96 % is obtained by heat-treating the wire in the pressurized atmosphere having the total pressure of at least 1 MPa and less than 50 MPa.

Preferably in the aforementioned method of manufacturing an oxide superconducting wire, the heat treatment step is carried out through hot isostatic pressing (HIP).

Thus, the oxide superconducting wire is so isotropically pressurized that the same is homogeneously prevented from gaps and blisters.

In the aforementioned method of manufacturing an oxide superconducting wire, the oxide superconductor is a Bi-Pb-Sr-Ca-Cu-O-based oxide superconductor including a Bi2223 phase containing bismuth, lead, strontium, calcium and copper at atomic ratios of (bismuth and lead):strontium:calcium:copper expressed as 2:2:2:3 in approximation.

Thus, gaps between crystals as well as blistering of the oxide superconducting wire are so suppressed that the critical current density can consequently be improved.

Preferably in the aforementioned method of manufacturing an oxide superconducting wire, the heat treatment step is carried out in an oxygen atmosphere, and the partial oxygen pressure is at least 0.003 MPa and not more than 0.02 MPa.

Thus, the partial oxygen pressure is so kept in the range of at least 0.003 MPa and not more than 0.02 MPa that a stable oxide superconducting phase is formed and the critical current density can be improved. A hetero phase is formed if the partial oxygen pressure exceeds 0.02 MPa, while the oxide superconducting phase is hard to form and the critical current density is reduced if the partial oxygen pressure is less than 0.003 MPa.

Preferably in the aforementioned method of manufacturing an oxide superconducting wire, the partial oxygen pressure is controlled to be increased following temperature rise in the pressurized atmosphere in temperature increase before the heat treatment in the heat treatment step.

The value of the partial oxygen pressure optimum for forming the oxide superconducting phase is increased following temperature rise. Thus, a proper partial oxygen pressure is attained also in the temperature increase before the heat treatment in the heat treatment step, whereby a stable oxide superconducting phase is formed and the critical current density can be improved.

Preferably in the aforementioned method of manufacturing an oxide superconducting wire, the total pressure in the pressurized atmosphere is controlled to be constant in the heat treatment.

In the heat treatment, the total pressure may exhibit a decreasing tendency due to consumption of oxygen gas resulting from oxidation of a bearer supporting the wire in a pressurizing vessel, hunting of a pressure regulator such as a dwelling valve during pressure control or pressure fluctuation in introduction of gas added for supplementing consumed oxygen. If this results in abrupt decompression in the vessel, the internal pressure of the wire reaches a high level as compared with the external pressure, to blister the wire. According to an aspect, however, the total pressure in the heat treatment is controlled to be constant, whereby the wire can be prevented from blistering resulting from abrupt decompression in the heat treatment.

Preferably in the aforementioned method of manufacturing an oxide superconducting wire, the heat treatment step is carried out in an oxygen atmosphere, and the partial oxygen pressure in the heat treatment is controlled to be constant in a fluctuation range within 10 %.

Thus, the partial oxygen pressure can be kept in the range optimum for forming an oxide superconducting phase regardless of temperature fluctuation, whereby a stable oxide superconducting phase is formed and the critical current density can be improved.

Preferably in the aforementioned method of manufacturing an oxide superconducting wire, gas is injected for supplementing pressure reduction resulting from temperature reduction in temperature reduction immediately after the heat treatment.

In the temperature reduction immediately after the heat treatment, pressure reduction follows temperature change. If a heating vessel is abruptly decompressed at this time, the internal pressure of the wire is increased as compared with the external pressure to blister the wire. According to an aspect, however, the gas is injected to supplement pressure reduction resulting from temperature reduction, whereby the wire can be prevented from blistering resulting from abrupt decompression in the temperature reduction immediately after the heat treatment.

Preferably in the aforementioned method of manufacturing an oxide superconducting wire, the decompression rate in the temperature reduction immediately after the heat treatment is controlled to not more than 0.05 MPa/min. if the metal covering the raw material powder includes silver and the ratio (hereinafter referred to as a silver ratio) of the area of a metal portion to the area of an oxide superconductor portion in a cross section of the wire after the heat treatment step is 1.5.

Thus, a more remarkable effect of preventing the wire from blistering resulting from abrupt decompression can be attained when the silver ratio is 1.5.

Preferably in the aforementioned method of manufacturing an oxide superconducting wire, the decompression rate for the total pressure in the pressurized atmosphere is controlled to not more than 0.05 MPa/min. when the temperature in the atmosphere is at least 200°C in the heat treatment step, if the metal covering the raw material powder includes silver and the silver ratio is 1.5.

If the heating vessel is abruptly decompressed when the temperature in the atmosphere is at least 200°C, the internal pressure of the wire is increased as compared with the external pressure, to blister the wire. Therefore, a more remarkable effect of inhibiting the wire from blistering resulting from abrupt decompression in the heat treatment step (before the heat treatment, in the heat treatment and after the heat treatment) is attained when the silver ratio is 1.5.

Preferably in the aforementioned method of manufacturing an oxide superconducting wire, the decompression rate in temperature reduction immediately after the heat treatment is controlled to not more than 0.03 MPa/min., if the metal covering the raw material powder includes silver and the silver ratio is 3.0.

Thus, a more remarkable effect of preventing the wire from blistering resulting from abrupt decompression can be attained when the silver ratio is 3.0.

Preferably in the aforementioned method of manufacturing an oxide superconducting wire, the decompression rate for the total pressure in the pressurized atmosphere is controlled to not more than 0.03 MPa/min. if the metal covering the raw material powder includes silver, the silver ratio is 3.0 and the temperature in the atmosphere is at least 200°C in the heat treatment step.

If the heating vessel is abruptly decompressed when the temperature in the atmosphere is at least 200°C, the internal pressure of the wire is increased as compared with the external pressure, to blister the wire. Therefore, a more remarkable effect of inhibiting the wire from blistering resulting from abrupt decompression in the heat treatment step (before the heat treatment, in the heat treatment and after the heat treatment) is attained when the silver ratio is 3.0.

Preferably in the aforementioned method of manufacturing an oxide superconducting wire, the decompression rate for the total pressure in the pressurized atmosphere is controlled to not more than 0.05 MPa/min if the total pressure of the pressurized atmosphere is at least 1 MPa in the heat treatment step.

If the heating vessel is abruptly decompressed when the total pressure in the atmosphere is at least 1 MPa, the internal pressure of the wire is increased as compared with the external pressure, to blister the wire. Therefore, a more remarkable effect of inhibiting the wire from blistering resulting from abrupt decompression in the heat treatment step (before the heat treatment, in the heat treatment and after the heat treatment) is attained.

The aforementioned method of manufacturing an oxide superconducting wire preferably further comprises a step of rolling the wire with a roll after the step of preparing the wire and before the heat treatment step, and the skin thickness of the wire after the rolling step is at least 20 $\mu$m.

Pinholes are mainly formed by holes externally penetrating toward an oxide superconductor filament when the surface of the wire is roughened due to friction between the wire and the roll. When the wire is rolled in such a state that the skin thickness of the oxide superconducting wire is at least 20 $\mu$m in every portion in the rolling step, however, no holes externally penetrate toward the oxide superconductor filament even if the surface of the wire is roughened by rolling, to form no pinholes. Thus, formation of gaps and blisters is suppressed through the aforementioned heat treatment step, and the critical current density can be improved. Throughout the specification, the term "pinhole" denotes a hole, externally penetrating toward the oxide superconducting wire filament, having a diameter allowing passage of the liquid refrigerant. Further, the term "wire having pinholes" denotes a wire including at least two pinholes in a length of 1000 m.

The aforementioned method of manufacturing an oxide superconducting wire preferably further comprises a step of applying silver or silver alloy to the surface of the said wire after the step of preparing the wire and before the heat treatment step.

The silver ratio of an oxide superconducting wire is minimized in order to increase the quantity of superconducting current feedable per unit area. In a wire having a small silver ratio, however, the ratio of a metal portion is so small that the skin thickness cannot be increased. Particularly in a wire having a skin thickness of less than 20 $\mu$m after a heat treatment step, pinholes are easily formed in treatment such as rolling before the heat treatment step. In the wire having pinholes, pressurizing gas infiltrates into the wire through the pinholes also when the aforementioned step of heat-treating the wire in the pressurized atmosphere is carried out. Therefore, difference between the internal and external pressures of the wire disappears to result in a small effect of preventing reduction of the critical current density by suppressing formation of gaps and blisters by pressurization. Thus, silver or a silver alloy is so applied to the surface of the wire after the step of preparing the wire and before the heat treatment step so that pinholes are covered with the silver or silver alloy and disappear from the surface. Therefore, the heat treatment step is carried out after removing pinholes from the wire, whereby no pressurizing gas infiltrates into the wire through pinholes in the heat treatment step. Thus, formation of gaps and blisters is suppressed through the aforementioned step of heat-treating the wire in the pressurized atmosphere, so that the critical current density can be improved.

The aforementioned method of manufacturing an oxide superconducting wire preferably further comprises a step of rolling the wire with a roll after the step of preparing the wire and before the heat treatment step, and the surface roughness Ry of a portion of the roll coming into contact with the wire is not more than 320 nm.

Thus, friction between the wire and the roll is so reduced that the surface of the wire is hardly roughened and a wire having no pinholes is obtained regardless of the skin thickness thereof. Therefore, no pressurizing gas infiltrates into the wire through pinholes in the heat treatment step. Thus, formation of gaps and blisters is suppressed through the aforementioned step of heat-treating the wire in the pressurized atmosphere regardless of the skin thickness of the wire, so that the critical current density can be improved. The term "surface roughness Ry" denotes the maximum height defined in JIS (Japanese Industrial Standards).

Preferably in the aforementioned method of manufacturing an oxide superconducting wire, the pressure is controlled to be increased stepwise following temperature rise in the atmosphere in temperature increase before the heat treatment in the heat treatment step.

In a wire having pinholes, pressurizing gas infiltrates into the wire through the pinholes also when the step of heat-treating the wire in a pressurized atmosphere is carried out by an ordinary pressurizing method, and hence difference between the internal and external pressures of the wire disappears to result in a small effect of preventing reduction of the critical current density resulting from formation of gaps and blisters by pressurization. When the pressure is controlled to be increased stepwise following temperature rise in the atmosphere, however, the external pressure is increased before the pressurizing gas infiltrates into the wire through pinholes. Thus, difference takes place between the internal and external pressures of the wire, so that formation of gaps and blisters is suppressed and the critical current density can be improved whether or not the wire has pinholes before the heat treatment step.

Preferably in the aforementioned method of manufacturing an oxide superconducting wire, the total pressure of the atmosphere is controlled to be increased at a rate of at least 0.05 MPa/min. in temperature increase before the heat treatment in the heat treatment step.

The speed of the pressurizing gas infiltrating into the wire through pinholes in the step of heat-treating the wire is less than about 0.05 MPa/min. Therefore, the pressure in the atmosphere can be regularly kept higher than the internal pressure of the wire by controlling the total pressure of the atmosphere to be continuously increased at a rate of at least 0.05 MPa/min. in temperature increase before the heat treatment. Thus, compressive force can be applied to the wire in temperature increase before the heat treatment whether or not the wire has pinholes in advance of the heat treatment step, whereby formation of gaps and blisters is suppressed. Consequently, reduction of the critical current density can be effectively suppressed by the heat treatment in the pressurized atmosphere of at least 1 MPa and less than 50 MPa.

Preferably in the aforementioned method of manufacturing an oxide superconducting wire, the total pressure in the atmosphere is controlled to be continuously increased in the heat treatment in the heat treatment step.

Thus, equalization of the internal pressure of the wire and the pressure of the atmosphere can be retarded in the heat treatment, so that the state where the pressure in the atmosphere is higher than the internal pressure of the wire can be kept for a longer period. Therefore, formation of gaps and blisters is suppressed in the heat treatment, and reduction of the critical current density can be effectively suppressed through the heat treatment in the pressurized atmosphere of at least 1 MPa and less than 50 MPa.

The aforementioned method of manufacturing an oxide superconducting wire preferably further comprises a step of rolling the wire after the step of preparing the wire and before the heat treatment step, and the draft of the wire in the rolling step is not more than 84 %, more preferably not more than 80 %.

When the step of heat-treating the wire is carried out in the pressurized atmosphere of at least 1 MPa and less than 50 MPa, the oxide superconducting wire is compressed also in the heat treatment step. Also when the step of rolling the wire is carried out with a draft of not more than 84 % lower than a conventional draft, therefore, the raw material powder is compressed in the subsequent heat treatment step, whereby the density of the superconductor filaments can consequently be increased. On the other hand, the step of rolling the wire is carried out with the draft of not more than 84 % lower than the conventional draft so that gaps are hardly formed in the raw material powder, whereby formation of gaps extending perpendicularly to the longitudinal direction of the oxide superconducting wire can be suppressed. Thus, the critical current density of the oxide superconducting wire can be improved. Further, the step of rolling the wire is so carried out with the draft of not more than 80 % that no gaps are formed in the raw material powder, whereby formation of gaps extending perpendicularly to the longitudinal direction of the oxide superconducting wire can be more suppressed.

Throughout this specification, the draft (%) is defined as follows:

[Num 1]

$$\text{Draft (\%)} = (1 - \text{thickness of wire after rolling} / \text{thickness of wire before rolling}) \times 100$$

Preferably in the aforementioned method of manufacturing an oxide superconducting wire, a plurality of times of heat treatment are performed on the wire, and at least one of the plurality of times of heat treatment is performed in a pressurized atmosphere having a total pressure of at least 1 MPa and less than 50 MPa.

Thus, gaps between oxide superconducting crystals formed in the heat treatment and blistering of the oxide superconducting wire can be suppressed.

An oxide superconducting wire having an oxide superconductor exhibiting a higher sintering density can be manufactured by the following manufacturing method. Further, the oxide superconducting wire can be reformed to an oxide superconducting wire having an oxide superconductor exhibiting a higher sintering density by the following reforming method:

The method of manufacturing an oxide superconducting wire comprises a step of preparing a wire having a configuration obtained by covering raw material powder for an oxide superconductor with a metal and a heat treatment step of heat-treating the wire in a pressurized atmosphere having a total pressure of at least 1 MPa and less than 50 MPa in heat treatment. In temperature increase before the heat treatment in the heat treatment step, pressurization is started from a temperature at which 0.2 % yield strength of the metal employed for covering is smaller than the total pressure in the heat treatment.

The method of reforming an oxide superconducting wire comprises a heat treatment step of heat-treating an oxide superconducting wire having a configuration obtained by covering an oxide superconductor with a metal in a pressurized atmosphere having a total pressure of at least 1 MPa and less than 50 MPa in heat treatment. In temperature increase before the heat treatment in the heat treatment step, pressurization is started from a temperature at which 0.2 % yield strength of the metal employed for covering is smaller than the total pressure in the heat treatment.

According to the manufacturing method or the reforming method for the oxide superconducting wire, a pressure is applied to the wire in the state where the 0.2 % yield strength of the metal employed for covering is smaller than the total pressure of the pressurized atmosphere in the heat treatment. Thus, a metal portion receiving compressive force resulting from pressurization is easily compressed due to an effect similar to that of hot working. Therefore, the wire is compressed before pressurizing gas infiltrates into the wire through pinholes, whereby formation of gaps and blisters can be sufficiently suppressed by pressurization. Consequently, the sintering density of the oxide superconductor can be improved, so that the critical current density of the oxide superconducting wire can be improved.

Another method of manufacturing an oxide superconducting wire comprises a step of preparing a wire having a configuration obtained by covering raw material powder for an oxide superconductor with a metal including silver and a heat treatment step of heat-treating the wire in a pressurized atmosphere having a total pressure of at least 1 MPa and less than 50 MPa in heat treatment. In temperature increase before the heat treatment in the heat treatment step, pressurization is started after the temperature of the atmosphere exceeds 400°C.

Another method of reforming an oxide superconducting wire comprises a heat treatment step of heat-treating an oxide superconducting wire having a configuration obtained by covering an oxide superconductor with a metal including silver in a pressurized atmosphere having a total pressure of at least 1 MPa and less than 50 MPa in heat treatment. In temperature increase before the heat treatment in the heat treatment step, pressurization is started after the temperature of the atmosphere exceeds 400°C.

According to the manufacturing method or the reforming method for the oxide superconducting wire, a pressure is applied to the wire in a state where 0.2 % yield strength of the metal including silver is reduced to a degree identical to the total pressure of the pressurized atmosphere in the heat treatment. Thus, a metal portion receiving compressive force resulting from pressurization is easily compressed due to an effect similar to that of hot working. Therefore, the wire is compressed before pressurizing gas infiltrates into the wire through pinholes, whereby formation of gaps and blisters can be sufficiently suppressed by pressurization. Consequently, the sintering density of the oxide superconductor can be improved, so that the critical current density of the oxide superconducting wire can be improved. An oxide superconducting wire having an oxide superconductor exhibiting a sintering density of at least 95 % is obtained by the aforementioned manufacturing method or the aforementioned reforming method, regardless of pinholes.

Preferably in each of the aforementioned manufacturing method and the aforementioned reforming method, pressurization is started after the temperature of the atmosphere exceeds 600°C in temperature increase before the heat treatment in the heat treatment step.

Thus, a pressure is applied to the wire in a state where 0.2 % yield strength of the metal including silver is reduced to about half the total pressure of the pressurized atmosphere in the heat treatment. Thus, a metal portion receiving compressive force resulting from pressurization is more easily compressed. Consequently, the sintering density of the oxide superconductor can be more improved, so that the critical current density of the oxide superconducting wire can be more improved. An oxide superconducting wire having an oxide superconductor exhibiting a sintering density of at least 97 % is obtained by the aforementioned manufacturing method or the aforementioned reforming method, regardless of pinholes.

Preferably in each of the aforementioned manufacturing method and the aforementioned reforming method, the pressing speed is at least 0.05 MPa/min.

The speed of the pressurizing gas infiltrating into the wire through pinholes in the heat treatment step is less than about 0.05 MPa/min. Therefore, the pressure in the atmosphere can be regularly kept higher than the internal pressure of the wire by controlling the total pressure of the atmosphere to be continuously increased at a rate of at least 0.05 MPa/min. in temperature increase before the heat treatment. Thus, compressive force can be applied to the wire in temperature increase before the heat treatment whether or not the wire has pinholes in advance of the heat treatment step, whereby formation of gaps and blisters is suppressed. Consequently, the sintering density of the oxide superconductor can be effectively improved by the heat treatment in the pressurized atmosphere of at least 1 MPa and less than 50 MPa, and the critical current density of the oxide superconducting wire can be effectively improved.

Preferably in each of the aforementioned manufacturing method and the aforementioned reforming method, the rate of pressurization is at least 0.1 MPa/min.

Thus, the pressure in the atmosphere can be kept further higher than the internal pressure of the wire. Therefore, compressive force can be further largely applied to the wire in temperature increase before the heat treatment whether or not the wire has pinholes in advance of the heat treatment step, whereby formation of gaps and blisters is suppressed. Consequently, the sintering density of the oxide superconductor can be more effectively improved by the heat treatment in the pressurized atmosphere of at least 1 MPa and less than 50 MPa, and the critical current density of the oxide superconducting wire can be more effectively improved.

When the pressing speed is set to at least 0.15 MPa/min. in both cases of starting pressurization after the temperature of the atmosphere reaches 400°C and 600°C respectively, an oxide superconducting wire having an oxide superconductor exhibiting a sintering density of at least 99 % is obtained regardless of pinholes.

Preferably in the aforementioned manufacturing method, the raw material powder for the oxide superconductor includes a Bi2223 phase, and the oxide superconducting wire is annealed in an atmosphere containing oxygen at a temperature of at least 100°C and not more than 600°C in the heat treatment step.

Thus, the critical current density $J_c$ at a low temperature of about 20 K is improved in the overall wire.

According to the superconducting device, the number of gaps in the oxide superconductor is so extremely small that a liquid refrigerant hardly infiltrates into the gaps of the oxide superconductor. When the temperature is increased from a state dipped in the liquid refrigerant to the ordinary temperature without temperature control, therefore, the quantity of vaporized liquid refrigerant is extremely small. Consequently, the internal pressure of the oxide superconducting wire is hardly increased and ballooning can be suppressed.

Brief Description of the Drawings

[Fig. 1A] A sectional view of a superconducting cable according to a first embodiment .
[Fig. 1B] An enlarged view of a cable core in Fig. 1A.
[Fig. 2] A partially fragmented perspective view conceptually showing the structure of an oxide superconducting wire.
[Fig. 3] A diagram showing steps of manufacturing the oxide superconducting wire.
[Fig. 4] A schematic sectional view of a hot isostatic pressing (HIP) apparatus.
[Figs. 5(a) to 5(d)] Conceptual views showing the behavior of gaps between oxide superconducting crystals stepwise.
[Fig. 6] A diagram showing the relation between the total pressure P (MPa) of a pressurized atmosphere and the number of blisters in a wire (number/10 m).
[Fig. 7] A diagram showing total pressures and partial oxygen pressures as to mixed gas prepared at a ratio of about 80 % of nitrogen and about 20 % of oxygen.
[Fig. 8] A diagram showing the relation between total pressures and oxygen concentrations in a case of setting a partial oxygen pressure constant.
[Fig. 9A] A diagram showing the relation between time and the temperature of a wire in a case of performing decompression rate control immediately after heat treatment.
[Fig. 9B] A diagram showing the relation between time and a total pressure in a vessel in the case of performing decompression rate control immediately after heat treatment.
[Fig. 10A] A graph showing the thicknesses of oxide superconducting wires having no pinholes before and after heat treatment in a pressurized atmosphere.
[Fig. 10B] A graph showing the thicknesses of oxide superconducting wires having pinholes before and after heat treatment in a pressurized atmosphere.
[Fig. 11] A partially fragmented perspective view conceptually showing the structure of an oxide superconducting wire having pinholes.
[Fig. 12] A schematic sectional view showing a rolling method in a second embodiment.
[Fig. 13] A diagram showing other steps of manufacturing an oxide superconducting wire.
[Fig. 14] A partially fragmented perspective view conceptually showing the structure of an oxide superconducting wire after a step of plating the wire with silver or a silver alloy.
[Fig. 15] A diagram showing the relation between temperatures and pressures in heat treatment and time in a fourth technique in the second embodiment.

[Fig. 16A] A diagram showing the relation between the temperature in a heat treatment step and time in a case where a silver ratio is 1.5 in the second embodiment.

[Fig. 16B] A diagram showing the relation between the pressure in the heat treatment step and time in the case where the silver ratio is 1.5 in the second embodiment.

[Fig. 16C] A diagram showing the relation between the oxygen concentration in the heat treatment step and time in the case where the silver ratio is 1.5 in the second embodiment.

[Fig. 16D] A diagram showing the relation between the partial oxygen pressure in the heat treatment step and time in the case where the silver ratio is 1.5 in the second embodiment.

[Fig. 17] A diagram showing the relation between temperatures and pressures in a heat treatment step and time in a fifth technique in the second embodiment.

[Fig. 18] A diagram showing the optimum combination of a temperature and a partial oxygen pressure in heat treatment.

[Fig. 19] A sectional view conceptually showing the structure of an oxide superconducting wire having gaps remaining therein.

[Fig. 20] A diagram schematically showing the relation between drafts and critical current densities in primary rolling in oxide superconducting wires.

[Fig. 21] A diagram showing exemplary relation between temperatures, total pressures and partial oxygen pressures in temperature increase before heat treatment and in heat treatment and time in a sixth technique in a sixth embodiment.

[Fig. 22] A diagram showing the relation between pressing speeds and sintering densities with reference to various temperatures for starting pressurization.

[Fig. 23] A diagram showing temperature dependency of 0.2 % yield strength of silver.

[Fig. 24] A diagram showing the relation between sintering densities of oxide superconductors and critical current values of oxide superconducting wires.

[Fig. 25] A diagram showing exemplary relation between temperatures, total pressures and partial oxygen pressures and time in a case of performing annealing after heat treatment in a seventh embodiment.

[Fig. 26] A diagram showing critical current values $I_c$ at respective temperatures (K) of oxide superconducting wires before annealing and after annealing performed at a temperature of 500°C.

Description of Reference Numerals

1, 1a, 1b oxide superconducting wire, 2 oxide superconductor filament, 3 sheath portion, 4 gas inlet, 5 upper lid, 6 cylindrical vessel cylinder, 7 thermal barrier, 8 treated product, 9 heater, 10 bearer, 11 lower lid, 12 superconducting crystal, 13 hot isostatic press, 14 pinhole, 15 roll, 15a surface of roll, 16 silver or silver alloy, 20 gap, 30 superconducting cable, 31 cable core, 32 former, 34 insulating paper, 35 kraft paper, 37 refrigerant passage, 38 adiabatic tube, 39 anticorrosive layer.

Embodiments are now described with reference to the drawings.

(First Embodiment)

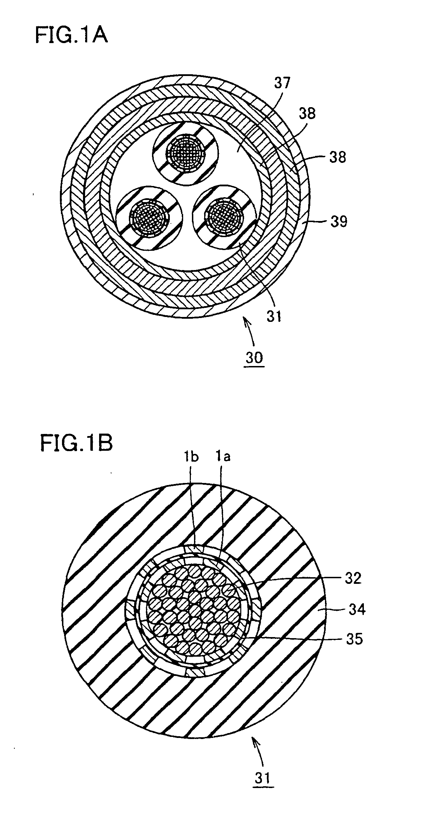

Fig. 1A is a sectional view of a superconducting cable according to a first embodiment, and Fig. 1B is an enlarged view of a cable core in Fig. 1A.

Referring to Figs. 1A and 1B, a superconducting cable 30 comprises cable cores 31, an adiabatic tube 38 and an anticorrosive layer 39. Each single-filamentary or multifilamentary stranded cable core 31 is inserted in a refrigerant passage 37 formed inside the adiabatic tube 38 and the anticorrosive layer 39. A refrigerant is circulated along the outer periphery of the cable core 31 in the refrigerant passage 37. The cable core 31 is constituted of a former (a plurality of copper strands) 32, a plurality of oxide superconducting wires 1a, kraft paper 35, another plurality of oxide superconducting wires 1b and insulating paper 34 successively from the inside. The tapelike oxide superconducting wires 1a and 1b are spirally wound on the outer periphery of the former 32 composed of a plurality of copper strands having an outer diameter of 20 mm, for example. The plurality of oxide superconducting wires 1a and the plurality of oxide superconducting wires 1b forming a laminated structure are insulated from each other through the kraft paper 35. In the lower layer of the plurality of oxide superconducting wires 1b, 13 oxide superconducting wires 1a are arranged at a pitch of 200 mm, for example. In the upper layer of the plurality of oxide superconducting wires 1b, 14 oxide superconducting wires 1a are arranged at a pitch of 200 mm, for example. Each of the oxide superconducting wires 1a and 1b has a rectangular section of 0.21 mm by 4.1 mm, for example. The oxide superconducting wires 1b are externally covered with the insulating paper 34 formed by polypropylene laminated paper (PPLP(R)), for example.

The structure of each oxide superconducting wire constituting the superconducting cable is now described.

Fig. 2 is a partially fragmented perspective view conceptually showing the structure of an oxide superconducting wire.

A multifilamentary oxide superconducting wire, for example, is described with reference to Fig. 2. The oxide superconducting wire 1 has a plurality of longitudinally extending oxide superconductor filaments 2 and a sheath portion 3 covering the same. The material for each of the plurality of oxide superconductor filaments 2 preferably has a Bi-Pb-Sr-Ca-Cu-O-based composition, for example, and a material including a Bi2223 phase having atomic ratios of (bismuth and lead):strontium:calcium:copper expressed substantially as 2:2:2:3 in approximation is particularly optimum. The material for the sheath portion 3 is composed of silver, for example.

While the multifilamentary wire has been described in the above, an oxide superconducting wire having a single-filamentary structure formed by a single oxide superconductor filament 2 covered with a sheath portion 3 may alternatively be employed.

A method of manufacturing the aforementioned oxide superconducting wire is now described.

Fig. 3 is a diagram showing steps of manufacturing the oxide superconducting wire.

Referring to Fig. 3, raw material powder for an oxide superconductor is first charged into a metal tube (step S1). This raw material powder for the oxide superconductor is composed of a material including a Bi2223 phase, for example.

The metal tube is preferably prepared from silver or a silver alloy having high thermal conductivity. Thus, heat generated when the superconductor partially causes quenching can be quickly removed from the metal tube.

Then, the metal tube charged with the raw material powder is worked into a wire of a desired diameter by wire drawing (step S2). Thus, a wire having a configuration obtained by covering the raw material powder for the oxide superconducting wire with a metal is obtained. In order to manufacture a multifilamentary wire, a plurality of drawn wires are inserted into a metal tube, to be further subjected to wire drawing. Primary rolling is performed on this wire (step S3), and first heat treatment is thereafter performed (step S4). An oxide superconducting phase is formed from the raw material powder through these operations. Secondary rolling is performed on the heat-treated wire (step S5). Thus, voids resulting from the first heat treatment are removed. Second heat treatment is performed on the secondarily rolled wire (step S6). Sintering of the oxide superconducting phase progresses and the oxide superconducting phase is singularized at the same time through the second heat treatment.

The oxide superconducting wire shown in Fig. 2, for example, can be manufactured by the aforementioned method.

According to this embodiment, at least either the first heat treatment (step S4) or the second heat treatment (step S6) is performed in a pressurized atmosphere to which a pressure of at least 1 MPa and less than 50 MPa is applied as a total pressure.

The heat treatment in this pressurized atmosphere is performed by hot isostatic pressing (HIP), for example. This hot isostatic pressing is now described.

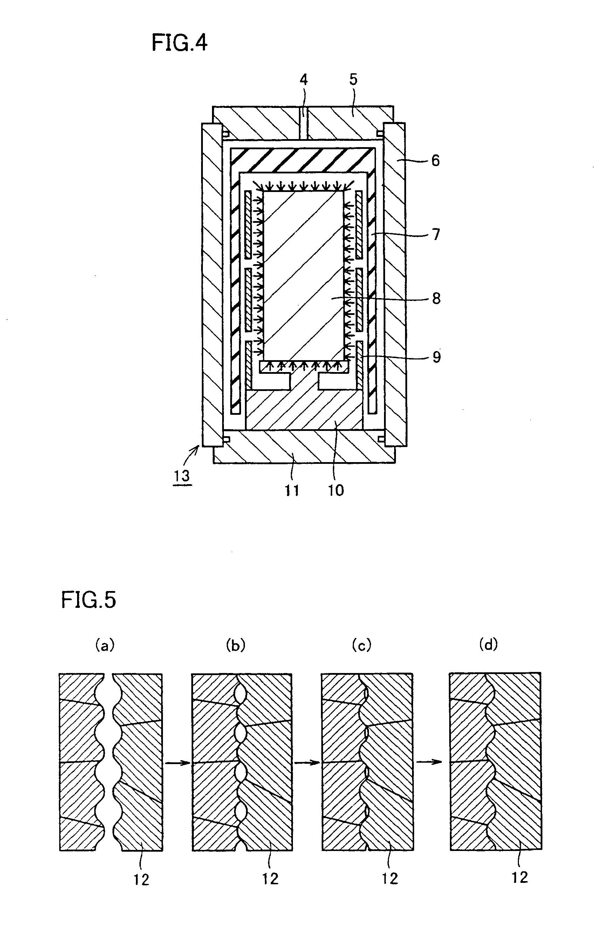

Fig. 4 is a schematic sectional view of a hot isostatic pressing (HIP) apparatus.

Referring to Fig. 4, an apparatus 13 for carrying out hot isostatic pressing is constituted of a pressure vessel cylinder 6, an upper lid 5 and a lower lid 11 closing both ends of the pressure vessel cylinder 6, a gas inlet 4 provided on the upper lid 5 for introducing gas into the pressure vessel cylinder 6, a heater 9 heating a treated product 8, a thermal barrier 7 and a bearer 10 supporting the treated product 8.

According to this embodiment, the bearer 10 supports a wire prepared by charging a metal tube with raw material powder and thereafter wire-drawing and rolling the same in the pressure vessel cylinder 6 as the treated product 8. In this state, prescribed gas is introduced into the pressure vessel cylinder 6 from the gas inlet 4, thereby forming a pressurized atmosphere of at least 1 MPa and less than 50 MPa in the pressure vessel cylinder 6 so that the wire 8 is heated with the heater 9 to a prescribed temperature under this pressurized atmosphere. This heat treatment is preferably performed in an oxygen atmosphere, and the partial oxygen pressure is preferably at least 0.003 MPa and not more than 0.02 MPa. Thus, heat treatment by hot isostatic pressing is performed on the wire 8.

According to this embodiment, the heat treatment is performed in the pressurized atmosphere of at least 1 MPa and less than 50 MPa as described above, for mainly attaining the following three effects:

First, the number of gaps formed between oxide superconducting crystals in the heat treatment can be reduced.

The number of gaps between oxide superconducting crystals mainly formed in heat treatment can be remarkably reduced by performing the heat treatment in a pressurized atmosphere of at least 1 MPa as compared with a case of less than 1 MPa.

Figs. 5(a) to 5(d) are conceptual diagrams showing behavior of gaps between oxide superconducting crystals stepwise.

Referring to Figs. 5(a) to 5(d), the contact area between the oxide superconducting crystals formed in the heat treatment is increased by plastic flow when the heat treatment is performed in a pressurized atmosphere, to reduce the number of gaps of several $\mu$m to several tens of $\mu$m present between the superconducting crystals (Fig. 5(a) → Fig. 5(b)). When this state is held, creep deformation is caused as shown in Fig. 5(c) to contract the gaps present on a junction interface while a contaminated portion such as an oxide film is partially broken/decomposed to cause diffusion of atoms and progress sintering. Finally, most of the gaps between the superconducting crystals disappear as shown in Fig. 5 (d), to form a stable junction interface.

To feed a current to a superconducting wire means to feed the current between superconducting crystals constituting the superconducting wire. In general, a junction between the superconducting crystals exhibiting a weak superconducting state (superconducting crystals are stronger in superconductivity than the junction between the crystals) limits the quantity of current feedable while maintaining the superconducting state (causing no electrical resistance) in a refrigerant (liquid nitrogen or liquid helium, for example) for using the superconducting wire or in refrigerator cooling. Gaps inevitably remain in the junction between the superconducting crystals in ordinary atmospheric pressure baking. Therefore, the number of the gaps between the superconducting crystals can be reduced (sintering density of the superconductor can be improved) by the heat treatment in the pressurized atmosphere, whereby the performance of the superconducting wire is improved and reduction of the critical current density can be prevented.

More specifically, the sintering density of an oxide superconductor heat-treated in the atmospheric pressure is 80 to 90 % as to an oxide superconducting wire including a Bi2223 phase, while the sintering density of an oxide superconductor filament prepared by the manufacturing method by setting the total pressure of the pressurized atmosphere to 10 MPa was at least 93 % and reduction of the number of gaps formed between oxide superconductor crystals was recognized.

An oxide superconducting wire obtained by the aforementioned manufacturing method is so applied to a superconducting device such as a superconducting cable that a liquid refrigerant hardly infiltrates into gaps of the oxide superconductor. Also when the temperature is increased without temperature control when the superconducting device is heated from a state dipped in the liquid refrigerant to the ordinary temperature, therefore, the liquid refrigerant is hardly vaporized. Consequently, the internal pressure of the oxide superconducting wire is hardly increased and the superconducting device such as a superconducting cable can be inhibited from ballooning.

Second, the oxide superconducting wire can be prevented from blistering resulting from the heat treatment.

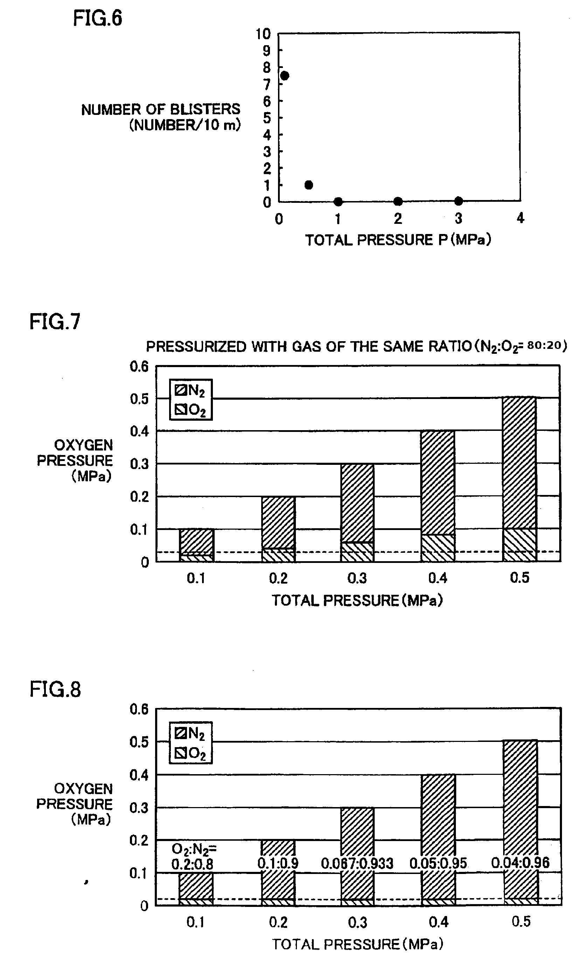

The inventor has investigated the number of blisters formed in a heat-treated wire when the total pressure was varied in heat treatment of an oxide superconducting wire in a pressurized atmosphere. Fig. 6 is a diagram showing the relation between the total pressure P (MPa) of the pressurized atmosphere and the number of blisters (number/10 m) in the wire.

Referring to Fig. 6, it is understood that the number of blisters in the oxide superconducting wire is remarkably reduced when the total pressure of the pressurized atmosphere exceeds 0.5 MPa and the blisters in the oxide superconducting wire substantially disappear when the total pressure exceeds 1 MPa. These results have conceivably been obtained for the following reason:

Powder of an oxide superconductor in a metal tube generally has a filling factor of about 80 % of theoretical density before sintering, and hence gas is present in gaps of the powder:- The gas in the gaps of the powder is cubically expanded when heated to a high temperature in heat treatment, to blister the wire. According to this embodiment, however, the heat treatment is performed in the pressurized atmosphere of at least 10 MPa, whereby the external pressure of the metal tube can be rendered larger than the internal pressure of the metal tube. Thus, the wire is conceivably prevented from blistering resulting from the gas in the gaps of the powder.

The inventor has further studied the cause for blistering of the wire, to also recognize that adsorbates such as carbon (C), water ($H_2O$) and oxygen ($O_2$) adhering to the raw material powder for the oxide superconductor are vaporized during sintering to expand the volume in the metal tube and blister the wire with the gas. However, this blistering of the wire resulting from vaporization of the adsorbates of the powder is also conceivably preventable by performing the heat treatment in the pressurized atmosphere of at least 1 MPa so that the external pressure can be rendered larger than the internal pressure of the metal tube.

Thus, not only blistering resulting from gas present in the gaps of the raw material powder for the oxide superconductor but also blistering resulting from vaporization of adsorbates adhering to the surfaces of grains thereof can conceivably be substantially eliminated by setting the total pressure of the pressurized atmosphere to at least 1 MPa. Blistering of the oxide superconducting wire causes reduction of the critical current density, and hence reduction of the critical current density can be prevented by preventing the wire from blistering.

Third, control of the partial oxygen pressure in the heat treatment can be simplified.

A 2223 phase of a Bi-based oxide superconductor is stably formed when the partial oxygen pressure is controlled to at least 0.003 MPa and not more than 0.02 MPa, regardless of the total pressure. In other words, a hetero phase such as $Ca_2PbO_4$ is formed if the partial oxygen pressure exceeds 0.02 MPa while a Bi2223 phase is hard to form if the partial oxygen pressure is less than 0.003 MPa, to reduce the critical current density.

Fig. 7 is a diagram showing total pressures and partial oxygen pressures as to mixed gas prepared at a ratio of about 80 % of nitrogen and about 20 % of oxygen. Fig. 8 is a diagram showing the relation between total pressures and oxygen concentrations in a case of setting the partial oxygen pressure constant.

Referring to Fig. 7, the partial oxygen pressure is equivalent to the level of 0.2 atm. (0.02 MPa) shown by a dotted line when the total pressure of the pressurized atmosphere is at the atmospheric pressure of 1 atm. (0.1 MPa), for example, whereby a Bi2223 phase is stably formed without partial oxygen pressure control. As the total pressure of the pressurized atmosphere is increased to 2 atm. (0.2 MPa), 3 atm. (0.3 MPa) ···, however, the partial oxygen pressure is also increased to exceed the level of 0.2 atm. (0.02 MPa) shown by the dotted line. Consequently, the Bi2223 phase is not stably formed. Therefore, the partial oxygen pressure must be controlled to at least 0.003 MPa and not more than 0.02 MPa by changing the mixing ratio of oxygen gas in the mixed gas, as shown in Fig. 8. The dotted line in Fig. 8 shows the level of 0.2 atm. (0.02 MPa), similarly to the dotted line in Fig. 7.

In practice, the partial oxygen pressure is controlled by monitoring the total pressure and the oxygen concentration. In other words, the partial oxygen pressure is calculated by multiplying the value of the total pressure by the oxygen concentration. Thus, if the total pressure is 50 MPa, for example, the oxygen concentration is 0.01 % when the heat treatment is performed with a partial oxygen pressure of 0.005 MPa. Therefore, the injected mixed gas must be controlled by measuring the oxygen concentration of 0.01 %. However, measurement of the oxygen concentration of 0.01 % leads to a large measurement error, and hence it is difficult to correctly control the partial oxygen pressure in a treatment chamber by controlling the oxygen gas in the injected mixed gas. According to this embodiment, the oxygen concentration can be kept at a level less influenced by a measurement error by setting the total pressure in the pressurized atmosphere to less than 50 MPa, whereby the partial oxygen pressure can be easily controlled.

When the heat treatment is performed in a pressurized atmosphere of at least 1 MPa, the decompression rate is preferably so controlled that no abrupt decompression takes place in the pressurized atmosphere in the heat treatment and after the heat treatment.

When the heat treatment is performed in the pressurized atmosphere of at least 1 MPa, external gas conceivably infiltrates into the wire through pinholes of the wire to equalize the internal and external pressures of the wire with each other. The gas emission from the inside cannot follow reduction of the external pressure and the internal pressure exceeds the external pressure to form blisters when the external pressure is reduced due to abrupt decompression in such a high-pressure atmosphere.

In order to prevent such blistering, therefore, mixed gas of inert gas such as Ar (argon) or $N_2$ (nitrogen) and $O_2$ gas is preferably injected into the vessel in the heat treatment so that the total pressure is constant. In temperature reduction immediately after the heat treatment, further, the mixed gas of inert gas and oxygen gas is injected into the vessel to supplement reduction of the pressure resulting from temperature reduction. Formation of blisters resulting from abrupt decompression can be prevented by controlling these decompression rates in the heat treatment and the temperature reduction immediately after the heat treatment.

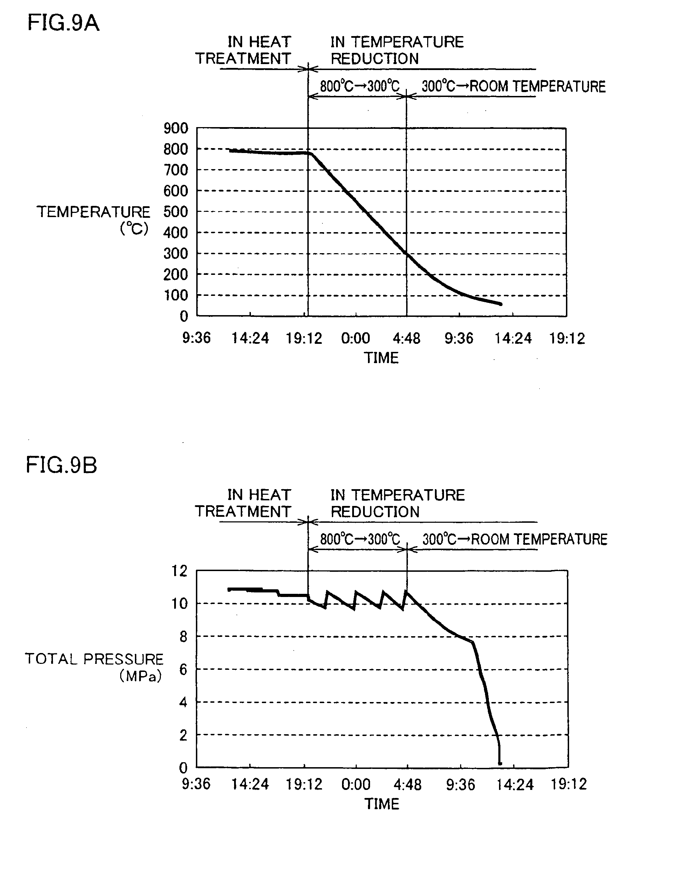

Fig. 9A is a diagram showing the relation between time and the temperature of a wire subjected to decompression rate control immediately after heat treatment. Fig. 9B is a diagram showing the relation between time and the total pressure in a vessel subjected to decompression rate control immediately after heat treatment.

Referring to Figs. 9A and 9B, the total pressure is controlled to be constant as shown in Fig. 9B in the heat treatment (temperature of about 800°C) shown in Fig. 9A. In other words, oxygen gas in the vessel is consumed in the heat treatment due to oxidation of a bearer supporting the wire in a heating vessel or the like, and hence the pressure in the vessel is reduced. In order to prevent this, the mixed gas is injected into the vessel for keeping the pressure constant. In temperature reduction (temperature range of about 800°C to about 300°C) immediately after the heat treatment shown in Fig. 9A, mixed gas is injected into the vessel for supplementing reduction of the pressure resulting from temperature reduction as shown in Fig. 9B, for controlling the decompression rate. In other words, the pressure of the gas also starts to abruptly lower on the basis of a state equation of gas due to reduction of the temperature in the temperature reduction, and hence decompression must be slowed down by injecting the mixed gas. In the range of not more than 300°C, the pressure in the wire is already sufficiently low since the temperature is low as compared with the case of about 800°C to about 300°C. Therefore, the wire is conceivably not blistered also when the decompression rate is not controlled.

The inventor has further found that the range of the decompression rate necessary for preventing the oxide superconducting wire from blistering varies with the ratio (silver ratio) of the area of a metal portion to the area of an oxide superconductor portion in a cross section of the wire after the heat treatment. In other words, the decompression rate in the temperature reduction (temperature range of 800°C to 300°C) immediately after the heat treatment is not more than 0.05 MPa/min. if the silver ratio is 1.5, while the decompression rate in the temperature reduction (temperature range of 800°C to 300°C) immediately after the heat treatment is not more than 0.03 MPa/min. if the silver ratio is 3.0.

While the method of manufacturing an oxide superconducting wire having a Bi2223 phase by hot isostatic pressing is described with reference to this embodiment, the manufacturing can also be carried out by a pressurizing method other than hot isostatic pressing so far as the same is a method of performing heat treatment in a pressurized atmosphere of at least 1 MPa and less than 50 MPa.

(Second Embodiment)

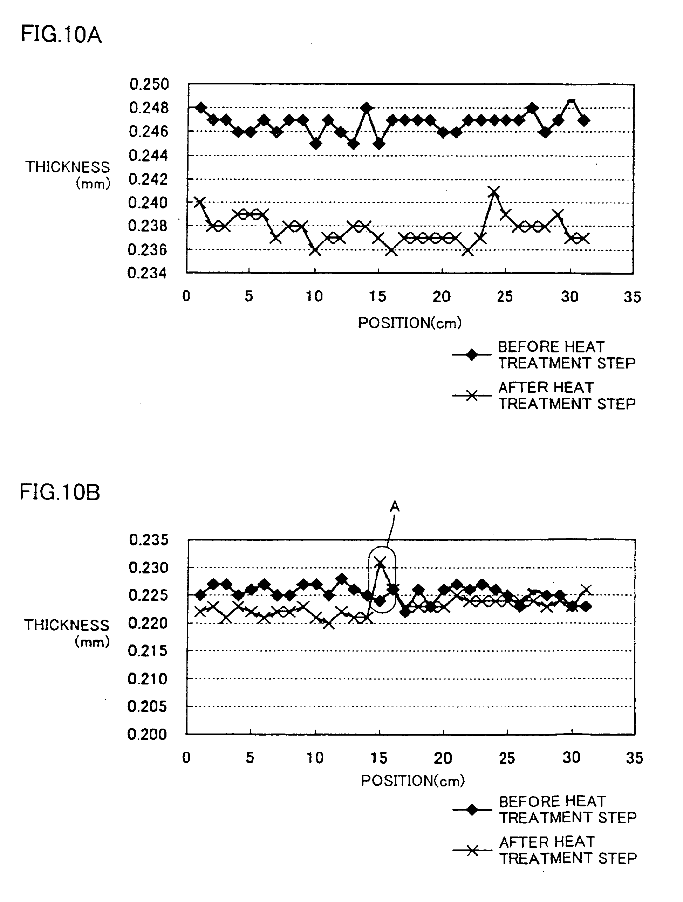

Fig. 10A is a graph showing thicknesses of oxide superconducting wires having no pinholes before and after heat treatment in a pressurized atmosphere. Fig. 10B is a graph showing thicknesses of oxide superconducting wires having pinholes.
Conditions for the heat treatment in Figs. 10A and 10B are a total pressure of 20 MPa, a partial oxygen pressure of 0.008 MPa, a temperature of 825°C in an atmosphere and a heat treatment time of 50 hours.

Referring to Fig. 10A, the thickness of each oxide superconducting wire having no pinholes is reduced by about 0.006 mm to 0.01 mm after the heat treatment. This is because the number gaps between oxide superconducting crystals is reduced and the oxide superconducting wire is inhibited from blistering due to the heat treatment in the pressurized atmosphere of the total pressure of 20 MPa. Referring to Fig. 10B, on the other hand, the thickness is reduced only by about 0.002 mm to 0.005 mm after the heat treatment in each oxide superconducting wire having pinholes, and reduction of the number of gaps between oxide superconducting crystals and suppression of blistering of the oxide superconducting wire are insufficiently attained. Further, the thickness of a portion (portion A) of the wire having included pinholes is increased after the heat treatment as compared with that before the heat treatment.

Thus, it has been recognized that formation of gaps and blisters can be effectively suppressed by heat treatment in the pressure range (at least 1 MPa and less than 50 MPa) of the first embodiment when no pinholes are present, while formation of gaps and blisters cannot be sufficiently suppressed simply by the heat treatment in the pressure range of the first embodiment when pinholes are present.

In the heat treatment in the pressurized atmosphere, plastic flow and creep deformation of superconducting crystals formed in the heat treatment result from the large pressure of at least 1 MPa outside the wire, whereby gaps between oxide superconducting crystals formed in the heat treatment are suppressed. Further, gas in gaps of oxide superconducting crystal powder formed in the heat treatment and gas adhering to the oxide superconducting crystal powder formed in the heat treatment can be inhibited from expansion in the heat treatment due to the pressure from outside a metal tube, whereby the oxide superconducting wire is inhibited from blistering. Consequently, reduction of the critical current density resulting from gaps or blisters is prevented.

In a wire having pinholes, however, pressurizing gas infiltrates into the wire through the pinholes despite the heat treatment in the aforementioned pressurized atmosphere, and hence no difference remains between the internal and external pressures of the wire and formation of gaps and blisters is not sufficiently suppressed by pressurization. Consequently, the effect of preventing reduction of the critical current density is reduced.

Therefore, there has been made a deep study, to find techniques capable of sufficiently suppressing formation of gaps and blisters by forming a wire having no pinholes before heat treatment.

According to a first technique, the skin thickness of an oxide superconducting wire is set to at least 20 $\mu$m after the rolling (step S3 or S5) and before the heat treatment (step S4 or step S6) in Fig. 3.

According to a second technique, the surface roughness Ry of portions of rolls, employed for the rolling (step S3 or S5) shown in Fig. 3, coming into contact with the wire is set to not more than 320 nm.

According to a third technique, the oxide superconducting wire is plated with silver or a silver alloy after the rolling (step S3 or S5) and before the heat treatment (step S4 or S6) in Fig. 3.

These techniques are now specifically described.

The inventors have found that no pinholes are formed in rolling (step S3 or S5) when the skin thickness W of the oxide superconducting wire is set to at least 20 $\mu$m in every portion after the rolling (step S3 or S5) and before the heat treatment (step S4 or S6) in Fig. 3 as the first technique.

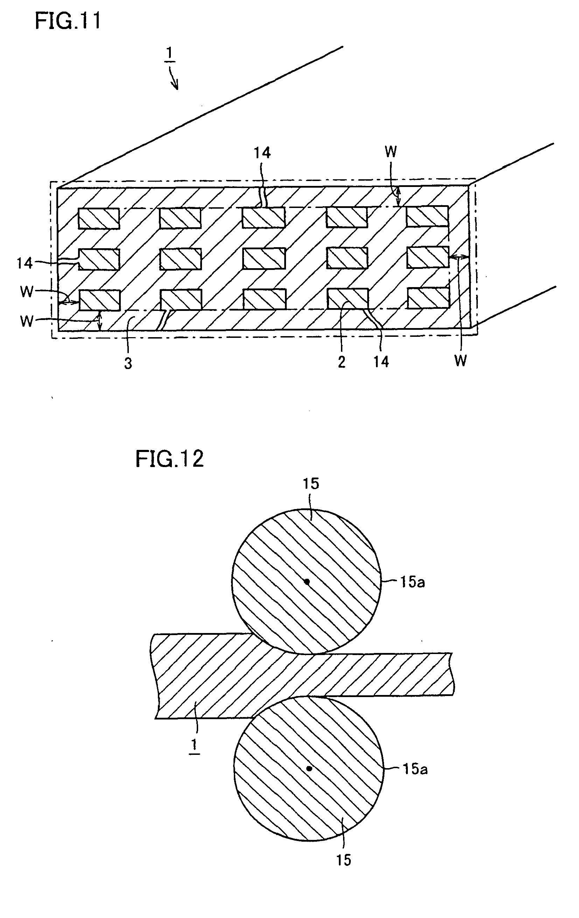

Fig. 11 is a partially fragmented perspective view conceptually showing the structure of an oxide superconducting wire having pinholes.

The skin thickness W denotes the distance W between oxide superconductor filaments 2 arranged on an outer peripheral portion in a section of a wire 1 and the outer surface of the wire 1 after rolling, as shown in Fig. 11. No pinholes 14 are formed when the skin thickness W is set to at least 20 $\mu$m, conceivably for the following reason:

Pinholes 14 are mainly formed by holes externally penetrating toward the oxide superconductor filaments 2 when the surface of the wire 1 is roughened due to friction between the wire 1 and pressure rolls. When the oxide superconducting wire 1 is so rolled that the skin thickness W is at least 20 $\mu$m in every portion after the rolling, however, no holes externally penetrate toward the oxide superconductor filaments 2, whereby no pinholes 14 are conceivably formed. The structure shown in Fig. 11 is substantially identical to that shown in Fig. 2 except the aforementioned point, and hence identical members are denoted by the same reference numerals, and redundant description is not repeated.

The inventors have found that a wire having no pinholes 14 is obtained before heat treatment if the aforementioned second and third techniques are employed also when the skin thickness W of the rolled oxide superconducting wire is less than 20 $\mu$m, and formation of gaps and blisters is consequently suppressed by heat treatment in a pressurized atmosphere while reduction of the critical current density is effectively prevented.

Fig. 12 is a schematic sectional view showing a rolling method according to the second embodiment.

Referring to Fig. 12, rolling is a working method of passing a plate- or bar-type material through a plurality of (generally two) rotating rolls 15 for reducing the thickness or the sectional area thereof while forming the section into a target shape. In the rolling, an oxide superconducting wire 1 is drawn into a clearance between the plurality of rolls 15 due to frictional force from the rolls 15, and deformed by compressive force from surfaces 15a of the rolls 15.

In the second technique, the rolls 15 having surface roughness Ry of not more than 320 nm on the surfaces 15a coming into contact with the wire 1 are employed in at least either the primary rolling (step S3) or the secondary rolling (step S5) shown in Fig. 3.

In other words, friction between the wire 1 and the surfaces 15a of the rolls 15 is so reduced that the surface of the wire 1 is hardly roughened and the wire 1 having no pinholes is obtained regardless of the skin thickness of the wire 1 if the surface roughness Ry of the surfaces 15a of the rolls 15 employed in rolling is not more than 320 nm. Therefore, pressurizing gas does not infiltrate into the wire 1 through pinholes in the heat treatment step. Thus, formation of gaps and blisters is suppressed through the aforementioned step of performing heat treatment in the pressurized atmosphere regardless of the skin thickness W of the wire 1, and reduction of the critical current density is effectively prevented.

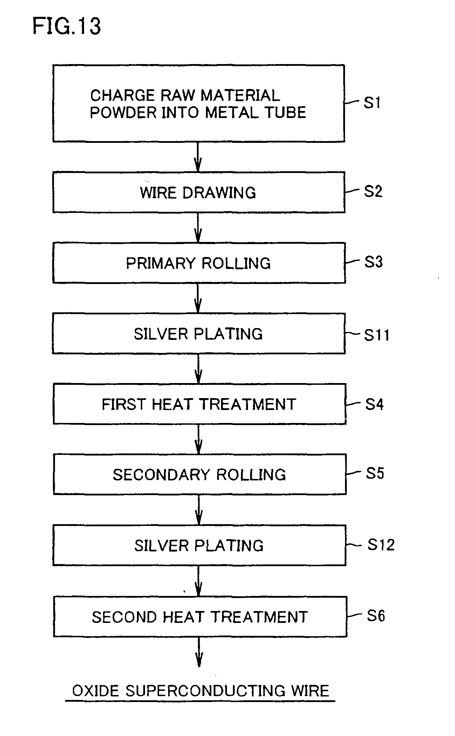

Fig. 13 is a diagram showing other steps of manufacturing an oxide superconducting wire.

In the third technique, a (step S 11 or S 12) of plating the surface of a wire with silver or a silver alloy is carried out after rolling (step S3 or S5) and before heat treatment (step S4 or S6), as shown in Fig. 13. This method is substantially identical to the method of Fig. 3 except that the plating (step S11 or S 12) is added, and hence corresponding steps are denoted by corresponding reference numerals, and redundant description is not repeated.

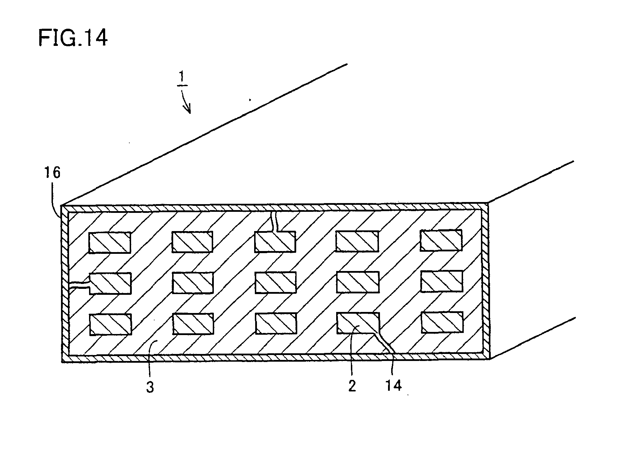

Fig. 14 is a partially fragmented perspective view conceptually showing the structure of an oxide superconducting wire after the step of plating the wire with silver or a silver alloy.

Referring to Fig. 14, the outer periphery of a sheath portion 3 is plated with silver or a silver alloy 16, whereby externally opening pinholes 14 are blocked with the silver or silver alloy 16. The remaining structure is substantially identical to the structure shown in Fig. 2, and hence identical members are denoted by the same reference numerals, and redundant description is not repeated.

In general, the silver ratio of the oxide superconducting wire 1 is minimized in order to increase the quantity of a superconducting current feedable per unit area. In the wire 1 having a small silver ratio, however, the ratio of a metal portion is so small that the skin thickness W cannot be increased. Therefore, the skin thickness of the wire 1 having a small silver ratio is less than 20 $\mu$m, and the pinholes 14 are easily formed in treatment (e.g. rolling) before the heat treatment step. In the wire 1 having the pinholes 14, formation of gaps and blisters is not sufficiently suppressed by pressurization, as hereinabove described. Consequently, the effect of preventing reduction of the critical current density is reduced. When the surface of the wire 1 is plated with the silver or silver alloy 16 before the heat treatment step, the pinholes 14 are blocked with the silver or silver alloy 16, to disappear from the surface. Therefore, the heat treatment step is carried out after the pinholes 14 disappear from the wire 1, whereby no pressurizing gas infiltrates into the wire 1 through the pinholes 14 in the heat treatment step. Thus, formation of gaps and blisters is suppressed through the aforementioned step of performing heat treatment in the pressurized atmosphere regardless of the value of the skin thickness W of the wire 1 and the value of the surface roughness Ry of the rolls 15 employed for rolling, and reduction of the critical current density is effectively prevented.

The formation of gaps and blisters is suppressed (sintering density is improved) also in the wire 1 having the pinholes 14 and reduction of the critical current density is effectively prevented when a fourth technique or a fifth technique described below is employed. In the fourth technique, the pressure is controlled to increase stepwise following temperature rise in temperature increase before the heat treatment in at least either the first heat treatment (step S4) or the second heat treatment (step S6) shown in Fig. 3. In the fifth technique, the total pressure of the atmosphere is controlled to increase at a rate of at least 0.05 MPa/min. in the temperature increase before the heat treatment in at least either the first heat treatment (step S4) or the second heat treatment (step S6) shown in Fig. 3. In the heat treatment, the total pressure of the atmosphere is controlled to continuously increase. In temperature reduction immediately after the heat treatment, further, control is made to supplement reduction of the pressure (to add a pressure) resulting from the temperature reduction. First, the fourth technique is described.

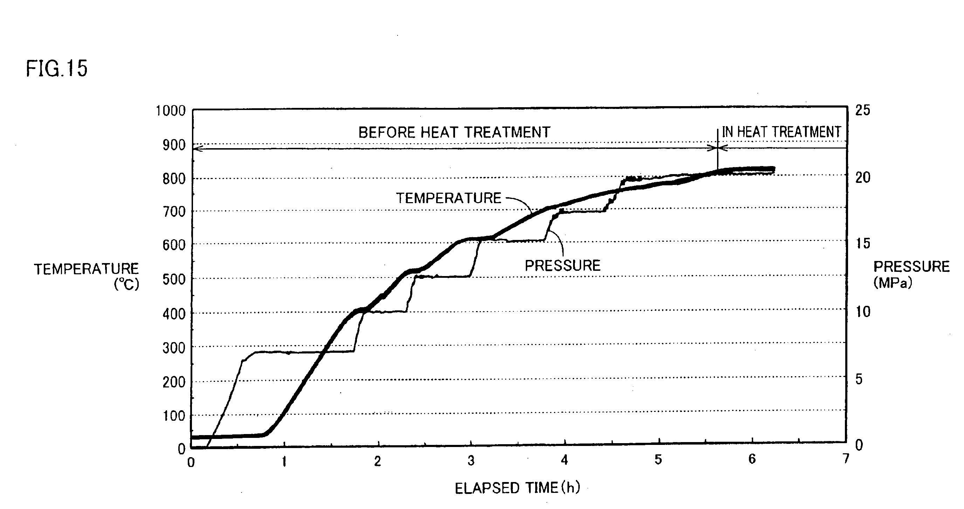

Fig. 15 is a diagram showing the relation between temperatures and pressures in heat treatment and time in the fourth technique of the second embodiment.

Referring to Fig. 15, the heat treatment is performed under conditions of a heat treatment temperature of 800°C and a pressure of 20 MPa. At this time, the pressure is controlled to increase stepwise following temperature rise. In other words, the pressure is controlled to repeat a process of increasing the pressure after keeping a prescribed pressure for a constant time and keeping the increased pressure for a constant time again in pressure increase. More specifically, the pressure is kept at about 7 MPa, about 10 MPa, about 12.5 MPa, about 15 MPa and about 17 MPa for a constant time in the pressure increase process. The timing for increasing the pressure after keeping the same for a constant time is decided on the basis of a measured value of the temperature in the atmosphere. In other words, the pressure is so controlled as to increase the pressure to about 7 MPa at the room temperature, increase the pressure to about 10 MPa when the temperature reaches about 400°C, increase the pressure to about 12.5 MPa when the temperature reaches 500°C, increase the pressure to about 15 MPa when the temperature reaches 600°C and increase the pressure to about 17 MPa when the temperature reaches 700°C. In order to form a stable oxide superconducting phase, the partial oxygen pressure is controlled to be regularly in the range of 0.003 to 0.008 MPa.

In a wire having pinholes, pressurizing gas infiltrates into the wire through the pinholes when a step of performing heat treatment in a pressurized atmosphere is carried out by a general pressurizing method, and hence no difference remains between the internal and external pressures of the wire and an effect of preventing reduction of the critical current density resulting from gaps and blisters by pressurization is small. When the pressure is controlled to increase stepwise following temperature rise in the fourth technique, however, the external pressure increases before the pressurizing gas infiltrates into the wire through the pinholes. Thus, difference is caused between the internal and external pressures of the wire, so that formation of gaps and blisters is suppressed (sintering density is improved) and reduction of the critical current density is effectively prevented whether or not the wire has pinholes before the heat treatment step.

Further, formation of gaps and blisters in the wire can be more effectively suppressed by combining the following technique with the aforementioned first to fourth techniques. This technique is now described.

In this technique, the decompression rate for the total pressure in the pressurized atmosphere is controlled to less than a constant rate in at least either the first heat treatment (step S4) or the second heat treatment (step S6) shown in Fig. 3 if the temperature of the atmosphere is at least 200°C in the heat treatment step.

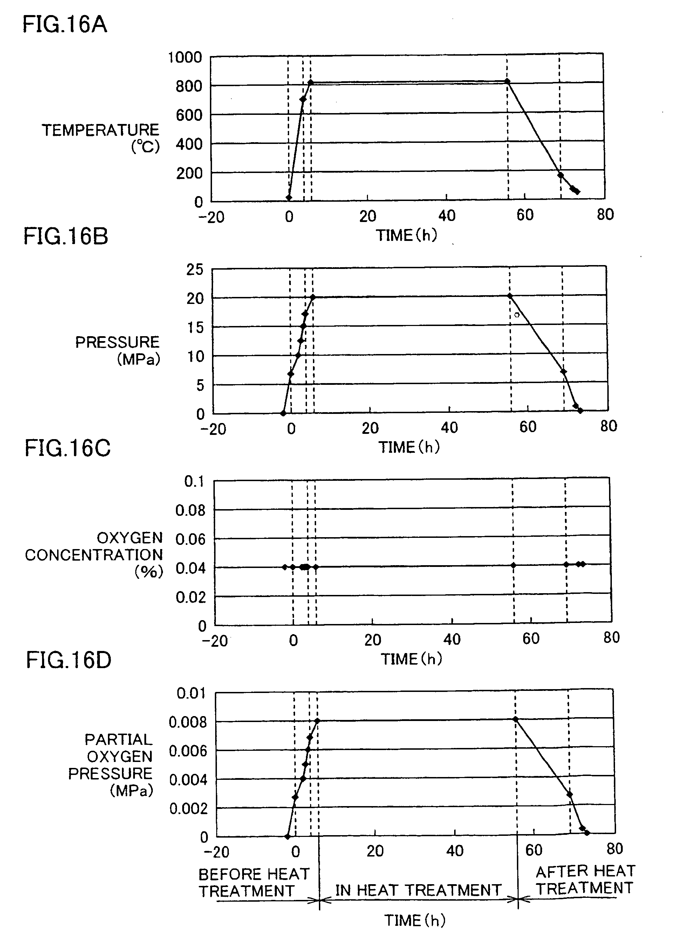

Fig. 16A is a diagram showing the relation between the temperature in the heat treatment step and time in a case where the silver ratio in the second embodiment is 1.5. Fig. 16B is a diagram showing the relation between the pressure in the heat treatment step and time in the case where the silver ratio in the second embodiment is 1.5. Fig. 16C is a diagram showing the relation between the oxygen concentration in the heat treatment step and time in the case where the silver ratio in the second embodiment is 1.5. Fig. 16D is a diagram showing the relation between the partial oxygen pressure in the heat treatment step and time in the case where the silver ratio in the second embodiment is 1.5.

Referring to Figs. 16A to 16D, the pressure is controlled to increase stepwise following temperature rise in the atmosphere in the temperature increase before the heat treatment, similarly to the aforementioned fourth technique. While the pressure appears not kept at a prescribed level for a constant time in Fig. 16B, the scale of the elapsed time in Fig. 16B is so larger than the scale in Fig. 15 that a pressure holding part seems to be omitted, and the pressure is kept at a prescribed level for a constant time similarly to the case of Fig. 15 in practice. The temperature and the pressure are set to 815°C and 20 MPa respectively through this temperature increase step, and heat treatment of 50 hours is performed in this state. In temperature increase before the heat treatment and in the heat treatment, the decompression rate for the total pressure in the pressurized atmosphere is controlled to not more than 0.05 MPa/min. if the temperature of the atmosphere is at least 200°C. After the heat treatment, the temperature is reduced at a rate of 50°C/h. Also after the heat treatment, the decompression rate for the total pressure in the pressurized atmosphere is controlled to not more than 0.05 MPa/min. if the temperature of the atmosphere is at least 200°C. If the temperature reduction rate after the heat treatment is 50°C/h., a natural decompression rate following temperature reduction is regularly not more than 0.05 MPa/min., and hence the decompression rate may not be controlled. Further, the oxygen concentration is kept at 0.04 % before the heat treatment, in the heat treatment and after the heat treatment. Thus, the partial oxygen pressure is regularly in the range of 0.003 to 0.008 MPa, and a stable oxide superconducting phase can be formed.

If the heating vessel is abruptly decompressed when the temperature in the atmosphere is at least 200°C, the internal pressure of the wire is increased as compared with the external pressure, to blister the wire. When the decompression rate for the total pressure in the pressurized atmosphere is controlled to less than a constant level, therefore, an effect of inhibiting the wire from blistering resulting from abrupt decompression during the heat treatment (before the heat treatment, in the heat treatment and after the heat treatment) is more remarkably attained.

As to a wire having a silver ratio of 3.0, the decompression rate is controlled to not more than 0.03 MPa/min. when the temperature of the atmosphere is at least 200°C.

The fifth technique is now described. In the fifth technique, the total pressure of the atmosphere is controlled to continuously increase at a rate of at least 0.05 MPa/min. in temperature rise before the heat treatment in at least either the first heat treatment (step S4) or the second heat treatment (step S6) shown in Fig. 3. In the heat treatment, the total pressure of the atmosphere is controlled to continuously increase. In temperature reduction immediately after the heat treatment, further, control is made to supplement reduction of the pressure (to add a pressure) resulting from the temperature reduction.

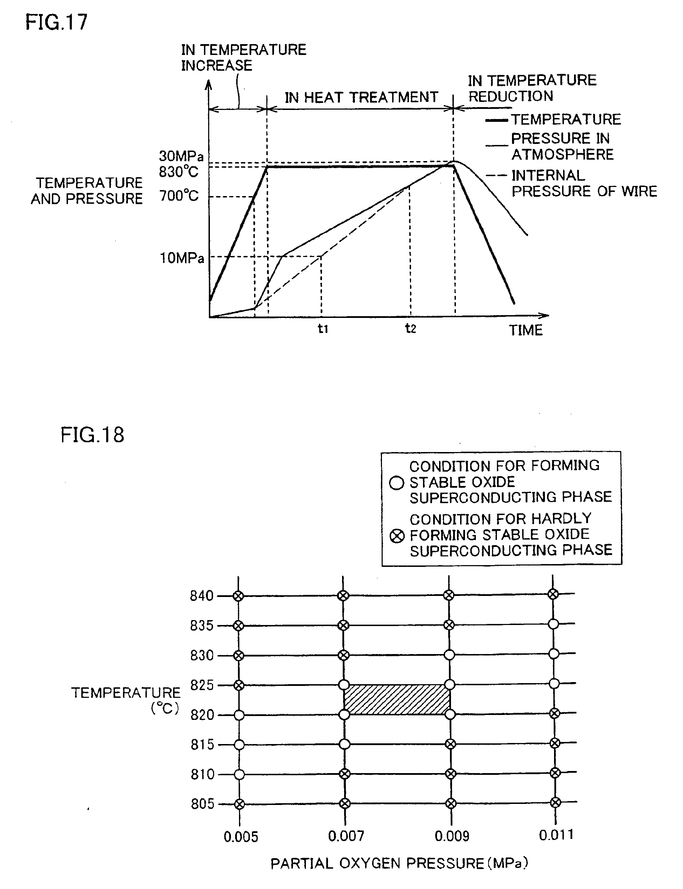

Fig. 17 is a diagram showing the relation between temperatures and pressures in the heat treatment step and time in the fifth technique of the second embodiment.

Referring to Fig. 17, the pressure is slowly increased according to a state equation of gas in the temperature increase before the heat treatment if the temperature of the atmosphere is not more than 700°C, for example. When the temperature of the atmosphere exceeds 700°C, the pressure of the atmosphere is increased to about 10 MPa. At this time, the pressure of the atmosphere is increased at a stroke at a pressing speed of at least 0.05 MPa/min.

The speed of the pressurizing gas infiltrating into a wire through pinholes is less than about 0.05 MPa/min.

when an oxide superconducting wire having pinholes is heat-treated in a pressurized atmosphere. Therefore, the pressure of the atmosphere can be continuously kept higher than the internal pressure of the wire in temperature increase before the heat treatment by controlling the total pressure of the atmosphere to continuously increase at a rate of at least 0.05 MPa/min. in the temperature increase before the heat treatment.

Thereafter the temperature is kept at 830°C, for example, in the heat treatment. On the other hand, the pressure of the atmosphere is continuously increased. While the pressing speed is preferably maximized in the heat treatment, the total pressure exceeds 50 MPa if the pressing speed is too high and hence the pressure must be continuously increased at such a proper pressing speed that the total pressure does not exceed 50 MPa in the heat treatment. Referring to Fig. 17, the pressure is increased to about 30 MPa. Therefore, the time equalizing the internal pressure of the wire and the pressure in the atmosphere with each other can be retarded from a time $t_1$ to a time $t_2$ as compared with a case of keeping the pressure constant in the heat treatment. Thus, the state where the pressure in the atmosphere is higher than the internal pressure of the wire can be kept for a longer time in the heat treatment.

Thereafter in the temperature reduction immediately after the heat treatment, the pressure also starts to lower along with reduction of the temperature in the atmosphere according to the state equation of gas. At this time, the pressure is controlled to supplement reduction of the pressure resulting from the temperature reduction (to add a pressure). In order to form a stable oxide superconducting phase, the partial oxygen pressure is controlled to be regularly in the range of 0.003 to 0.008 MPa.

According to the fifth technique, the pressure in the atmosphere exceeds the internal pressure of the wire in the temperature increase before the heat treatment, whereby compressive force can be applied to the wire. Further, the state where the pressure in the atmosphere is higher than the internal pressure of the wire can be kept for a longer time in the heat treatment. Consequently, formation of gaps and blisters is suppressed in the temperature increase before the heat treatment and in the heat treatment, and reduction of the critical current density can be effectively suppressed through the heat treatment in the pressurized atmosphere of at least 1 MPa and less than 50 MPa.

While the case of carrying out the step of plating the wire with the silver or silver alloy has been described with reference to this embodiment, plating can also be carried out through a sputtering step, for example, so far as the silver or silver alloy is applied to the wire in this step. Figs. 15 and 16A to 16D show specific control conditions for temperatures, pressures, oxygen concentrations and partial oxygen pressures. The pressure may be controlled to increase stepwise following temperature increase, and the decompression rate for the total pressure in the pressurized atmosphere may be controlled to not more than 0.05 MPa/min. when the temperature in the atmosphere is at least 200°C.

Formation of pinholes can be prevented, or formation of gaps and blisters in the wire can be effectively suppressed upon formation of pinholes, by combining the first to fifth techniques of this embodiment with the heat treatment conditions of the first embodiment.

Formation of gaps and blisters of the wire can be more effectively suppressed by properly combining the first to fifth techniques of this embodiment.

The fifth technique of this embodiment has been described with reference to the case of making control to supplement reduction of the pressure (to add a pressure) resulting from the temperature reduction in the temperature reduction immediately after the heat treatment, but the pressure in the atmosphere may be controlled to continuously increase at least in the heat treatment.

(Third Embodiment)

An optimum partial oxygen pressure in temperature increase before heat treatment and in the heat treatment is shown in Fig. 18.

Fig. 18 is a diagram showing the optimum combination of a temperature and a partial oxygen pressure in the heat treatment.

Referring to Fig. 18, it is understood that a stable oxide superconducting phase is formed and the critical current density is improved in the temperature range of at least 815°C and not more than 825°C when the partial oxygen pressure is 0.007 MPa, for example. While this is not shown in the figure, a stable oxide superconducting phase is formed and the critical current density is improved in the temperature range of at least 750°C and not more than 800°C, preferably in the temperature range of at least 770°C and not more than 800°C when the partial oxygen pressure is 0.003 MPa. When the partial oxygen pressure is 0.02 MPa, a stable oxide superconducting phase is formed and the critical current density is improved in the temperature range of at least 820°C and not more than 850°C, preferably in the temperature range of at least 830°C and not more than 845°C. Further, it has also been recognized that the partial oxygen pressure must be controlled in the range of at least 0.00005 MPa and not more than 0.02 MPa when the temperature is not more than 650°C.

From the aforementioned relation between the temperature and the partial oxygen pressure, the value of the partial oxygen pressure optimum for forming an oxide superconducting phase is increased following temperature rise. Therefore, the partial oxygen pressure can be set in the range optimum for forming an oxide superconducting phase by controlling the partial oxygen pressure to increase following temperature rise in the atmosphere. Thus, a stable oxide superconducting phase is formed and the critical current density can be improved.

When the wire is held at a constant temperature in the heat treatment, fluctuation (error) of several °C is frequently caused in the temperature. Considering the relation between this temperature fluctuation and the optimum range of the partial oxygen pressure, the optimum partial oxygen pressure is at least 0.006 MPa and not more than 0.01 MPa when the wire is held at 822.5°C, for example, while the optimum partial oxygen pressure is at least 0.07 MPa and not more than 0.011 MPa when the temperature fluctuates to 825°C. When the temperature fluctuates to 820°C, the optimum partial oxygen pressure is at least 0.005 MPa and not more than 0.009 MPa. Therefore, it follows that the partial oxygen pressure may be controlled to be constant in the fluctuation range (slanted portion in Fig. 18) of at least 0.007 MPa and not more than 0.009 MPa when the wire is held at 822.5°C, in order to regularly attain the optimum partial oxygen pressure despite such temperature fluctuation.

This fluctuation range of the partial oxygen pressure is about 10 % of the value of the partial oxygen pressure. Therefore, the partial oxygen pressure in the heat treatment is so controlled to be constant in the fluctuation range within 10 % that the partial oxygen pressure can be set in the optimum partial oxygen pressure range regardless of temperature fluctuation, whereby a stable oxide superconducting phase is formed and the critical current density can be improved.

The exemplary numerical range of the optimum partial oxygen pressure in the temperature increase before the heat treatment and in the heat treatment has been described with reference to this embodiment but the partial oxygen pressure may be controlled to increase following temperature rise in the atmosphere.

(Fourth Embodiment)

In order to further improve the critical current density of the oxide superconducting wire, the controlled decompression rate for a total pressure in heat treatment at 0.05 MPa/min. shows a relation between the value of the total pressure and blistering of the wire.

Raw material powder having composition ratios of Bi:Pb:Sr:Ca:Cu = 1.82:0.33:1.92:2.01:3.02 was prepared. This raw material powder was heat-treated at 750°C for 10 hours, and thereafter heat-treated at 800°C for 8 hours. Thereafter powder obtained by pulverization was heat-treated at 850°C for 4 hours, and thereafter pulverized again. Powder obtained by pulverization was heat-treated under decompression, and thereafter charged into a metal tube of silver having an outer diameter of 36 mm and an inner diameter of 31 mm. Then, the metal tube charged with the powder was subjected to wire drawing. Further, 61 drawn wires were bundled up and engaged in a metal tube having an outer diameter of 36 mm and an inner diameter of 31 mm. Then, wire drawing and primary rolling were performed for obtaining a tape-like superconducting wire, having a Bi2223 phase, of 0.25 mm in thickness and 3.6 mm in width. Then, first heat treatment was performed on this wire. The first heat treatment was performed in the atmosphere at a heat treatment temperature of 842°C for a heat treatment time of 50 hours. Then, second heat treatment was performed after performing secondary rolling. The second heat treatment was performed by setting the partial oxygen pressure to 0.008 MPa, the heat treatment temperature to 825°C and the heat treatment time to 50 hours, controlling the decompression rate for the total pressure in the heat treatment to not more than 0.05 MPa/min. and varying the total pressure as shown in Table 1. After the second heat treatment, presence/absence of blisters in the wire was investigated. Table 1 shows the total pressures and presence/absence of blisters in the wire.

[Table 1]

| Total Pressure (MPa) | Expansion of Wire |
|---|---|
| 0.1 | no |
| 0.2 | no |
| 0.3 | no |
| 0.4 | no |
| 0.5 | no |
| 0.8 | no |
| 1.0 | yes |
| 2.0 | yes |
| 3.0 | yes |
| 5.0 | yes |

(continued)

| Total Pressure (MPa) | Expansion of Wire |
|---|---|
| 10.0 | yes |
| 20.0 | yes |
| 30.0 | yes |

From the results shown in Table 1, the wire is blistered when the total pressure is at least 1 MPa. Thus, the decompression rate in the pressurized atmosphere must be controlled to not more than 0.05 MPa/min. when the total pressure is at least 1 MPa, in order to suppress blistering of the wire.

Then, the heat treatment temperature for the second heat treatment was set to 500°C, for similarly investigating presence/absence of blisters of the wire. Table 2 shows the total pressures and presence/absence of blisters of the wire.

[Table 2]

| Total Pressure (MPa) | Expansion of Wire |
|---|---|
| 0.1 | no |
| 0.2 | no |
| 0.3 | no |
| 0.4 | no |
| 0.5 | no |
| 0.8 | no |
| 1.0 | yes |
| 2.0 | yes |
| 3.0 | yes |
| 5.0 | yes |
| 10.0 | yes |
| 20.0 | yes |
| 30.0 | yes |

From the results shown in Table 2, the wire is blistered when the total pressure is at least 1 MPa, also when the heat treatment temperature is 500°C. Thus, the decompression rate in the pressurized atmosphere must be controlled to not more than 0.05 MPa/min. when the total pressure is at least 1 MPa also when the heat treatment temperature is 500°C, in order to suppress blistering of the wire.

(Fifth Embodiment)

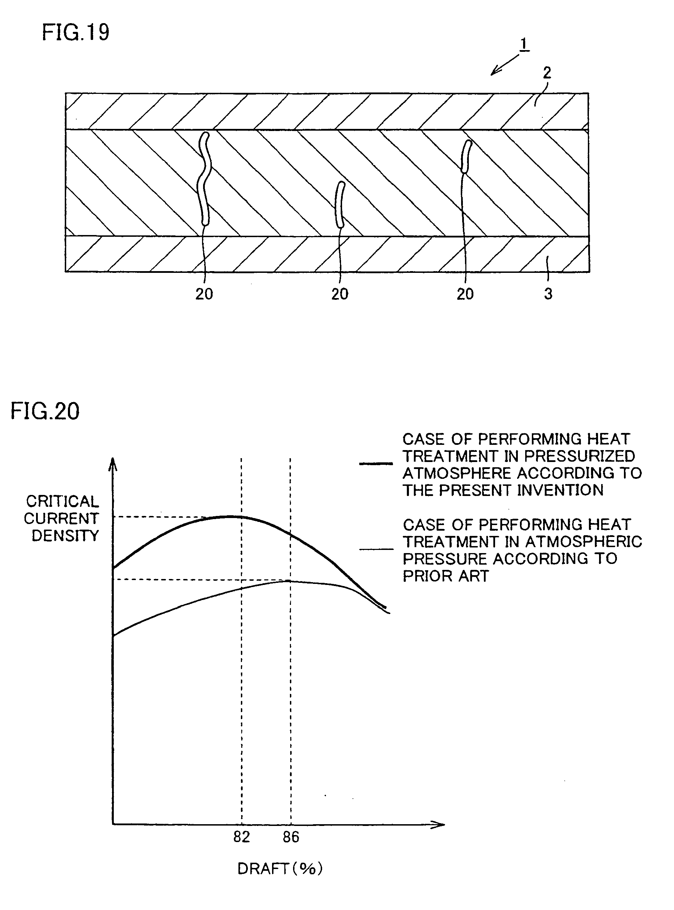

Fig. 19 is a sectional view conceptually showing the structure of an oxide superconducting wire having gaps remaining therein.

Referring to Fig. 19, gaps elongated in the longitudinal direction (transverse direction in Fig. 19) substantially disappear while gaps 20 extending perpendicularly to the longitudinal direction slightly remain in a superconductor filament 2 of an oxide superconducting wire 1 after heat treatment in a pressurized atmosphere having a total pressure of at least 1 MPa and less than 50 MPa. Fig. 19 shows a single-filamentary oxide superconducting wire having a single superconductor filament.

The number of the gaps 20 extending perpendicularly to the longitudinal direction of the oxide superconducting wire 1 is hard to reduce by the heat treatment in the pressurized atmosphere. This is conceivably for the following reason: In the pressurized atmosphere, a pressure is equivalently applied to all surfaces of the oxide superconducting wire. Oxide superconducting crystals cause creep deformation due to this pressure, to contract gaps present on a junction interface between the crystals. Thus, the number of gaps formed between the oxide superconducting crystals is reduced. However, the oxide superconducting wire 1 has a shape elongated in the longitudinal direction, and hence force is hardly transmitted in the longitudinal direction and the wire 1 is hardly compressed in the longitudinal direction. Consequently, the number of the gaps 20 extending perpendicularly to the longitudinal direction of the oxide superconducting wire 1 is hardly reduced by the heat treatment in the pressurized atmosphere.

The gaps 20 extending perpendicularly to the longitudinal direction of the oxide superconducting wire 1, blocking a current in the superconductor filament, are one of factors reducing the critical current density of the oxide superconducting wire 1. When formation of the gaps 20 is suppressed, therefore, the critical current density of the oxide superconducting wire 1 can be further improved.

Formation of gaps extending perpendicularly to the longitudinal direction of the oxide superconducting wire can be suppressed before the heat treatment and the critical current density of the oxide superconducting wire can consequently be improved by setting the draft of the oxide superconducting wire to not more than 84 %, preferably not more than 80 %, in the primary rolling (step S5) in Fig. 3. The reason for this is now described.

The primary rolling is a step carried out for increasing the density of the raw material powder charged into the metal tube. As the draft of the oxide superconducting wire is increased (working ratio is increased) in the primary rolling, the density of the raw material powder charged into the metal tube is increased. When the density of the raw material powder is increased, the density of superconducting crystals formed by the subsequent heat treatment (step S4 and step S5) is increased to improve the critical current density of the oxide superconducting wire.

When the draft of the oxide superconducting wire is increased in the primary rolling, however, the following three phenomena resulting from the increased working ratio may be recognized: First, gaps (cracks) are formed in the raw material powder. Second, sausaging is easily caused to render the shape of a filament in the oxide superconducting wire nonuniform in the longitudinal direction. Third, a portion of the superconductor filament having a locally increased sectional area due to the sausaging easily comes into another superconductor filament to cause bridging. All of these phenomena may serve as factors reducing the critical current density of the oxide superconducting wire.

Therefore, the primary rolling must be performed with a draft increasing the density of the raw material powder without forming gaps or the like in the raw material powder. In the conventional primary rolling, the oxide superconducting wire has been rolled with a draft of about 86 to 90 %.

If the heat treatment is performed in the pressurized atmosphere of at least 1 MPa and less than 50 MPa, however, the effect of compressing the oxide superconducting wire is attained also in the heat treatment. Also when the primary rolling is performed with a draft of not more than 84 %, therefore, the raw material powder is compressed through the subsequent heat treatment in the pressurized atmosphere, whereby the density of the superconductor filament forming the oxide superconducting wire can consequently be increased. On the other hand, the primary rolling is performed with the draft of not more than 84 % so that gaps are hardly formed in the raw material powder, whereby formation of gaps extending perpendicularly to the longitudinal direction of the oxide superconducting wire can be suppressed. In addition, the primary rolling is so performed with the draft of not more than 80 % that absolutely no gaps are formed in the raw material powder. The critical current density of the oxide superconducting wire can be improved for the above reasons.

Fig. 20 is a diagram schematically showing the relation between drafts and critical current densities in primary rolling in oxide superconducting wires.

Referring to Fig. 20, the critical current density of the oxide superconducting wire is maximized when heat treatment is performed in the atmosphere and the primary rolling is performed with a draft of about 86 %. When the heat treatment is performed in the pressurized atmosphere, on the other hand, the critical current density is maximized when the primary rolling is performed with a draft of about 82 %. Thus, it is understood that optimum the draft for the primary rolling for improving the critical current density of the oxide superconducting wire shifts to a lower side when the heat treatment is performed in the pressurized atmosphere of at least 1 MPa and less than 50 MPa.

In order to confirm the aforementioned effect, the inventors have prepared oxide superconducting wires according to this embodiment under the following conditions, for measuring critical current densities.

On the basis of the steps of manufacturing an oxide superconducting wire shown in Fig. 3, metal tubes were charged with raw material powder and subjected to wire drawing. Then, tape-like superconducting wires were obtained by performing primary rolling. The primary rolling was performed with two types of drafts of 82 % and 87 %. Further, rolls of 100 mm in diameter and lubricating oil having kinetic viscosity of 10 $mm^2$/s were employed for the primary rolling. Then, first heat treatment was performed on these wires. The first heat treatment was performed by setting the partial oxygen pressure, the heat treatment temperature and the heat treatment time to 0.008 MPa, 830°C and 30 hours respectively. Then, secondary rolling was performed. The secondary rolling was performed with a draft of 5 to 30 % and rolls of 300 mm in diameter, with no lubricating oil. Then, second heat treatment was performed. The second heat treatment was performed by setting the total pressure, the partial oxygen pressure, the heat treatment temperature and the heat treatment time to 25 MPa, 0.008 MPa, 820°C and 50 hours respectively. After the second heat treatment, the critical current densities of the obtained oxide superconducting wires were measured.

Consequently, the oxide superconducting wire subjected to the primary rolling with the draft of 87 % exhibited a critical current density of 30 kA/$cm^2$. On the other hand, the oxide superconducting wire subjected to the primary rolling with the draft of 82 % exhibited a critical current density of 40 kA/$cm^2$. It is understood from the aforementioned results that formation of gaps extending perpendicularly to the longitudinal direction of the oxide superconducting wire can be suppressed before the heat treatment and the critical current density of the oxide superconducting wire can consequently be improved by setting the draft of the oxide superconducting wire to not more than 84 % in the primary rolling (step S5).

The exemplary kinetic viscosity of the lubricating oil in rolling and the exemplary diameter of the rolls employed for rolling have been shown in this embodiment, but the draft of the wire in the rolling step may simply be not more than 84 %.

(Sixth Embodiment)

The formation of gaps and blisters is further suppressed and reduction of the critical current density is effectively prevented also in the wire 1 having the pinholes 14 when a sixth technique described below is employed. They have further found that ballooning can be further suppressed upon temperature increase without temperature control in an oxide superconducting wire manufactured with the sixth technique.

In the sixth technique, pressurization is started after the temperature of the atmosphere exceeds 400°C, preferably 600°C, in temperature increase before heat treatment in either the first heat treatment (step S4) or the second heat treatment (step S6) shown in Fig. 3. The pressing speed is preferably set to at least 0.05 MPa/min., more preferably at least 0.1 MPa/min.

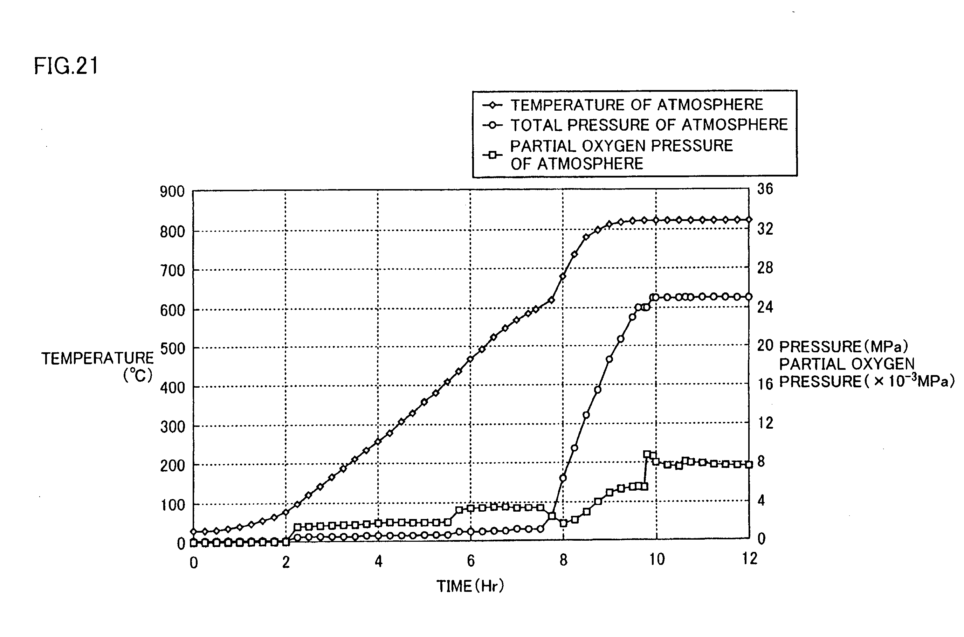

Fig. 21 is a diagram showing exemplary relation between temperatures, total pressures and partial oxygen pressures in temperature increase before heat treatment and in the heat treatment and time in the sixth technique in a sixth embodiment.

Referring to Fig. 21, the temperature of the atmosphere is slowly increased up to 820°C. The pressure of the atmosphere is slowly increased according to the state equation of gas when the temperature is less than 600°C. Pressurization is started after the temperature of the atmosphere reaches 600°C, and the pressurization is performed up to about 25 MPa at a pressing speed of about 0.1 MPa/min. The partial oxygen pressure is kept in the rage of at least 0.003 MPa and less than 0.02 MPa. The critical current density of an oxide superconducting wire can be further improving by performing heat treatment under these conditions. In order to confirm the effect of the aforementioned heat treatment method, the inventors have heat-treated oxide superconducting wires with various temperatures for starting pressurization as described below, and measured sintering densities of the prepared oxide superconducting wires respectively.

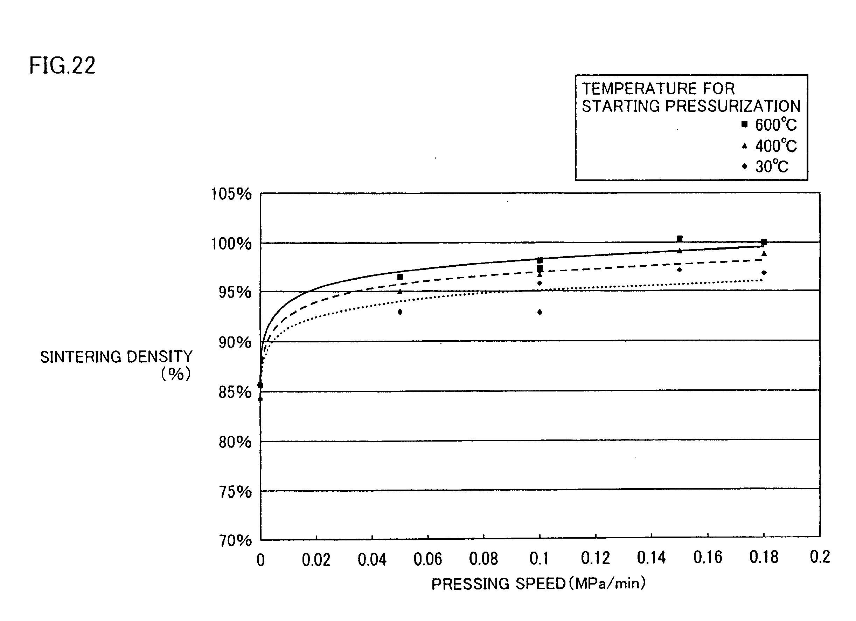

Fig. 22 is a diagram showing the relation between pressing speeds and sintering densities with reference to various temperatures for starting pressurization.

Referring to Fig. 22, the sintering density of an oxide superconductor filament (oxide superconductor) is about 93 % to 96 % with a pressing speed of at least 0.05 MPa in a case of starting pressurization when the temperature of the atmosphere is 30°C. In a case of starting pressurization when the temperature of the atmosphere reaches 400°C, on the other hand, the sintering density of the oxide superconductor filament is at least 95 % with a pressuring speed of at least 0.05 MPa/min. When pressurization is started after the temperature of the atmosphere reaches 600°C, further, the sintering density of the oxide superconductor filament is at least about 97 % with a pressuring speed of at least 0.05 MPa/min., and the sintering density of the oxide superconductor filament is at least about 98 % with a pressing speed of at least 0.1 MPa/min. In both cases of starting pressurization after the temperature of the atmosphere reaches 400°C and starting pressurization after the temperature reaches about 600°C, in addition, the sintering density of the oxide superconductor filament is at least about 99 % with a pressing speed of at least 0.15 MPa/min.

The sintering density is conceivably improved with the pressing speed of at least 0.05 MPa since the speed of the pressurizing gas infiltrating into the wire through pinholes is less than about 0.05 MPa/min. and the wire is pressurized at a speed higher than this infiltration speed so that the pressure in the atmosphere can regularly be kept higher than the internal pressure of the wire. According to the results shown in Fig. 12, the sintering density of the oxide superconductor filament is improved when pressurization is started after the temperature of the atmosphere exceeds 400°C, preferably 600°C. Further, it is understood that the sintering density of the oxide superconductor filament is further improved when the pressing speed is preferably set to at least 0.05 MPa/min., more preferably to at least 0.1 MPa/min. This is conceivably for the following reason:

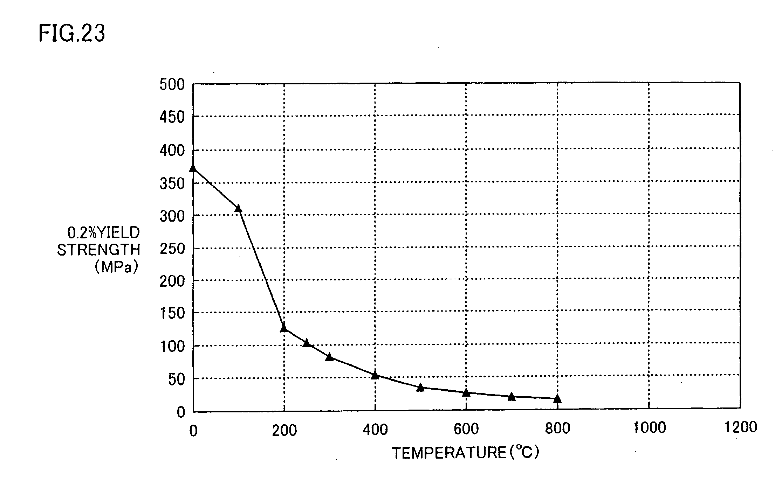

Fig. 23 is a diagram showing temperature dependency of 0.2 % yield strength of silver.

Referring to Fig. 23, the 0.2 % yield strength is about 370 MPa when the atmosphere is at the room temperature, and reduced following temperature rise in the atmosphere. More specifically, the 0.2 % yield strength is reduced to about 50 MPa when the temperature of the atmosphere reaches 400°C, and the 0.2 % yield strength is reduced to about 25 MPa when the temperature of the atmosphere reaches 600°C. Thus, the 0.2 % yield strength of silver is reduced to a degree substantially identical to the total pressure (at least 1 MPa and less than 50 MPa) of the aforementioned pressurized atmosphere when the temperature of the atmosphere is 400°C. When the temperature of the atmosphere is 600°C, the 0.2 % yield strength of silver is reduced to about half the total pressure (at least 1 MPa and less than 50 MPa) of the aforementioned pressurized atmosphere. According to the aforementioned technique, it follows that a pressure is applied to the wire in a state where the strength of a sheath portion is reduced. Therefore, the sheath portion is easily compressed by compressive force resulting from pressurization through an effect similar to that of hot working.

Consequently, the wire is compressed before pressurizing gas infiltrates into the wire through pinholes, whereby formation of gaps and blisters can be sufficiently suppressed by pressurization for improving the sintering density of the oxide superconductor filament. The values of the 0.2 % yield strength shown in Fig. 23 were obtained by performing a tensile test defined in JIS (Japan Industrial Standard) on a pure silver wire of 1.5 mm in diameter.

The sintering density of the oxide superconductor filament in Fig. 22 is calculated by the following method: First, an oxide superconducting wire of 5 g (= $M_t$ (g)) is dissevered. Then, the dissevered oxide superconducting wire is dipped in alcohol, for measuring the weight (W(g)) of the wire in alcohol and calculating buoyancy acting on the oxide superconducting wire. The volume ($V_t$ (cm$^3$)) of the oxide superconducting wire is calculated with known alcohol density ($\rho$ = 0.789 (g/cm$^3$)). More specifically, $V_t$ is calculated through the following formulas (1) and (2), assuming that $F_t$ represents the buoyancy:

$$F_t = M_t - W \ \ldots \ (1)$$

$$V_t = F_t/\rho \ \ldots \ (2)$$

Then, the oxide superconducting wire is dissolved in nitric acid so that the solution is subjected to ICP (inductive coupled plasma) emission spectroscopy, thereby determining silver and calculating the ratio (Y) of silver in the weight of the oxide superconducting wire. The weight ($M_f$(g)) of an oxide superconductor filament portion and the weight ($M_s$ (g)) of a sheath portion are calculated from the weight of the oxide superconducting wire through the following formulas (3) and (4):

$$M_s = M_t \times Y \ \ldots \ (3)$$

$$M_f = M_t - M_s \ \ldots \ (4)$$

Then, the volume (V, (cm$^3$)) of the sheath portion is calculated from the known silver density (10.5 (g/cm$^3$)), and the volume ($V_f$(cm$^3$)) of the oxide superconductor filament is calculated from the volume of the sheath portion. Further, the density $\rho_f$ of the oxide superconductor filament is calculated from the volume of the oxide superconductor filament. More specifically, $\rho_f$ is calculated through the following formulas (5) to (7):

$$V_s = M_s/10.5 \ \ldots \ (5)$$

$$V_f = V_t - V_s \ \ldots \ (6)$$

$$\rho_f = M_f/V_f \ \ldots \ (7)$$

On the other hand a value 6.35 g/cm$^3$ is employed as the theoretical density of the oxide superconductor filament. This value is calculated by the following method: The atomic ratios of a Bi2223 phase in the oxide superconductor filament are calculated by ICP emission spectroscopy and EDX (energy dispersive X-ray spectroscopy). The lattice constant of the Bi2223 phase is obtained by X-ray diffraction, for calculating the values of a- and c-axes. The theoretical density is calculated from these values.

The sintering density of the oxide superconductor filament is calculated from the ratio between the density of the oxide superconductor filament and the theoretical density of the oxide superconductor filament obtained by the aforementioned method. More specifically, the sintering density is calculated through the following formula (8):

$$\text{sintering density (\%)} = (\rho_f/6.35) \times 100 \ \ldots \ (8)$$

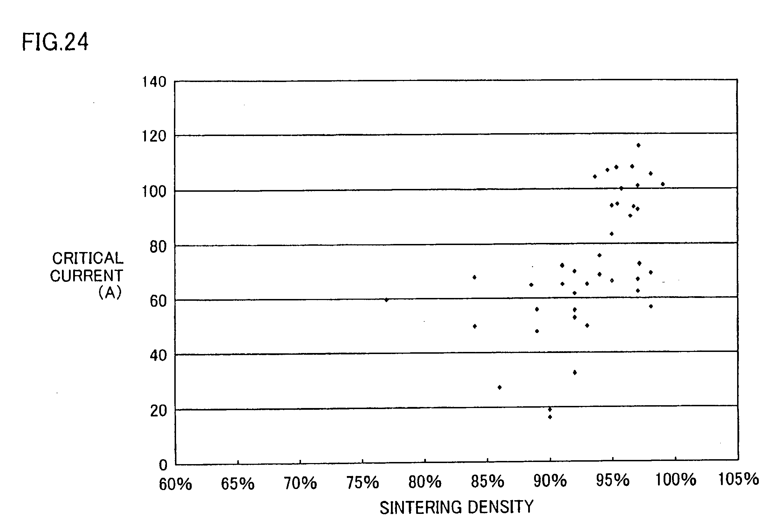

Fig. 24 is a diagram showing the relation between sintering densities of oxide superconductor filaments and critical current values of oxide superconducting wires.

Referring to Fig. 24, the critical current values of oxide superconducting wires having sintering densities of not more than about 95 % are less than 80 A, while the critical current values of oxide superconducting wires having sintering densities of at least about 95 % are mainly in a range exceeding 80 A. The critical current value is obtained by multiplying the critical current density by the sectional area of the oxide superconductor filament, and hence the critical current density is proportionate to the critical current value. Therefore, the critical current density is improved in an oxide superconducting wire having a high sintering density. This is conceivably because a large quantity of current flows through the superconductor filament since the number of gaps between crystals of the superconductor filament is small in the oxide superconducting wire having a high sintering density.

From the aforementioned results shown in Figs. 22 and 24, it is understood that the sintering density of the oxide superconductor filament is improved to improve the critical current density of the oxide superconducting wire when pressurization is started after the temperature of the atmosphere exceeds 400°C, more preferably 600°C, preferably at a speed of at least 0.05 MPa/min., more preferably at least 0.1 MPa/min.

An oxide superconducting wire having a sintering density of at least 95 %, preferably at least 99 %, is obtained by the aforementioned manufacturing method. The oxide superconducting wire obtained by the aforementioned manufacturing method is so applied to a superconducting device such as a superconducting cable that a liquid refrigerant further hardly infiltrates into gaps of an oxide superconductor. Also when the superconducting device is heated from a state dipped in the liquid refrigerant to the room temperature without temperature control, therefore, the liquid refrigerant is hardly vaporized. Consequently, the internal pressure of the oxide superconducting wire is so hardly increased that the superconducting device such as a superconducting cable can be further inhibited from ballooning.

In order to confirm the aforementioned effect, the inventors have made the following experiment:

Two types of oxide superconducting wires were prepared through the manufacturing method shown in Fig. 3. The first oxide superconducting wire was heat-treated at a temperature of 820°C for 50 hours with a pressure of 30 MPa and a partial oxygen pressure of 0.008 MPa in second heat treatment (step S6). In temperature increase before the second heat treatment (step S6), pressurization was started after the temperature in the atmosphere reached 600°C, with control substantially similar to the control of the total pressure, the partial oxygen pressure and the temperature shown in Fig. 21. The second oxide superconducting wire was heat-treated with the atmospheric pressure in both of first heat treatment (step S4) and second heat treatment (step S6). Superconducting cables 30 similar to that shown in Fig. 1A were prepared from the two types of oxide superconducting wires obtained in the aforementioned manner respectively. The respective superconducting cables 30 were dipped in liquid nitrogen for 24 hours, and heated to the room temperature without controlling the rate of temperature increase. Thereafter presence/absence of ballooning was investigated. Consequently, the superconducting cable 30 formed by the oxide superconducting wire heat-treated with the atmospheric pressure was ballooned. On the other hand, the superconducting cable 30 employing the oxide superconducting wire subjected to the control of the total pressure, the partial oxygen pressure and the temperature similar to that shown in Fig. 21 exhibited absolutely no ballooning. Thus, it is understood that a superconducting cable having an oxide superconducting wire manufactured by the aforementioned method can be inhibited from ballooning.

In the method of manufacturing an oxide superconducting wire according to this embodiment, a pressure is applied to the wire in such a state that the 0.2 % yield strength of the sheath portion is reduced to a degree substantially identical to the total pressure of a pressurized atmosphere in heat treatment. Thus, the sheath portion is easily compressible by compressive force resulting from pressurization due to an effect similar to that of hot working. Therefore, the wire is compressed before pressurizing gas infiltrates into the wire through pinholes, whereby formation of gaps and blisters can be sufficiently suppressed by pressurization. Consequently, the sintering density of the oxide superconductor filament can be improved for improving the critical current density of the oxide superconducting wire.

Preferably in the aforementioned manufacturing method, pressurization is started after the temperature of the atmosphere exceeds 600°C in temperature increase before heat treatment in the heat treatment step.

Thus, the pressure is applied to the wire in a state where the 0.2 % yield strength of the sheath portion is reduced to about half the total pressure of the pressurized atmosphere in the heat treatment. Therefore, the sheath portion is further easily compressible by the compressive force resulting from pressurization. Consequently, the sintering density of the oxide superconducting wire filament can be further improved for further improving the critical current density of the oxide superconducting wire.

Preferably in the aforementioned manufacturing method, the pressing speed is at least 0.05 MPa/min., more preferably at least 0.1 MPa/min.

Thus, the sintering density of the oxide superconductor filament can be further improved for further improving the critical current density of the oxide superconducting wire.

Preferably in the aforementioned manufacturing method, the heat treatment step is carried out in an oxygen atmosphere, and the partial oxygen pressure is at least 0.003 MPa and not more than 0.02 MPa.

Thus, a stable oxide superconducting phase is so formed that the critical current density can be improved. A hetero phase is formed if the partial oxygen pressure exceeds 0.02 MPa, while the oxide superconducting wire is hard to form and the critical current density is reduced if the partial oxygen pressure is less than 0.003 MPa.

The method (method of manufacturing an oxide superconducting wire) of improving the critical current density by performing a prescribed heat treatment method in at least either the first heat treatment (step S4) or the second heat treatment step S6) shown in Fig. 3 has been shown in this embodiment. However, the manufacturing is also applicable as a heat treatment step performed on the manufactured oxide superconducting wire (i.e., the oxide superconducting wire after completion of the steps S1 to S6 in Fig. 3), i.e., as a method of reforming an oxide superconducting wire, in addition to this case. Also when the heat treatment is employed as a method of reforming an oxide superconducting wire, the sintering density of an oxide superconductor can be improved for improving the critical current density of the oxide superconducting wire.

The case of heat-treating the oxide superconducting wire having the sheath portion of silver in the pressurized atmosphere having the total pressure of at least 1 MPa and less than 50 MPa in the heat treatment and starting pressurization after the temperature of the atmosphere exceeds 400°C in the temperature increase before the heat treatment in the heat treatment step has been shown in this embodiment. the present invention is not restricted to this case but In this case, heat treatment is performed in a pressurized atmosphere having a total pressure of at least 1 MPa and less than 50 MPa in the heat treatment, and pressurization is started from a temperature at which at least the 0.2 % yield strength of the metal is smaller than the total pressure (at least 1 MPa and less than 50 MPa) in the heat treatment. Thus, a pressure is applied to the wire in a state where the 0.2 % yield strength of the metal is smaller than the total pressure of the pressurized atmosphere in the heat treatment, whereby a portion of the metal is easily compressible by compressive force resulting from pressurization. Therefore, the sintering density of the oxide superconducting wire can be improved for improving the critical current density of the oxide superconducting wire for a reason similar to that in the aforementioned oxide superconducting wire having the sheath portion of silver.

(Seventh Embodiment)

A bismuth (Bi)-based oxide superconducting wire is generally known as one of oxide superconducting wires. This Bi-based oxide superconducting wire can be used at the liquid nitrogen temperature, and can attain a relatively high critical current density. Further, this Bi-based oxide superconducting wire, which can be relatively easily elongated, is expected for application to a superconducting cable or magnet. However, there has been such a problem that a conventional Bi-based oxide superconducting wire is unsuitable for application requiring high performance under a low temperature due to a low critical current density ($J_c$) under a low temperature of about 20 K.

In this relation, the critical current density of a Bi-based oxide superconducting wire at a low temperature of about 20 K can be improved by combining the following technique with the aforementioned techniques. This technique is now described.

In this technique, a wire is annealed in an atmosphere containing oxygen at a temperature of at least 100°C and not more than 600°C in at least either the first heat treatment (step S4) or the second heat treatment (step S6) shown in Fig. 3.

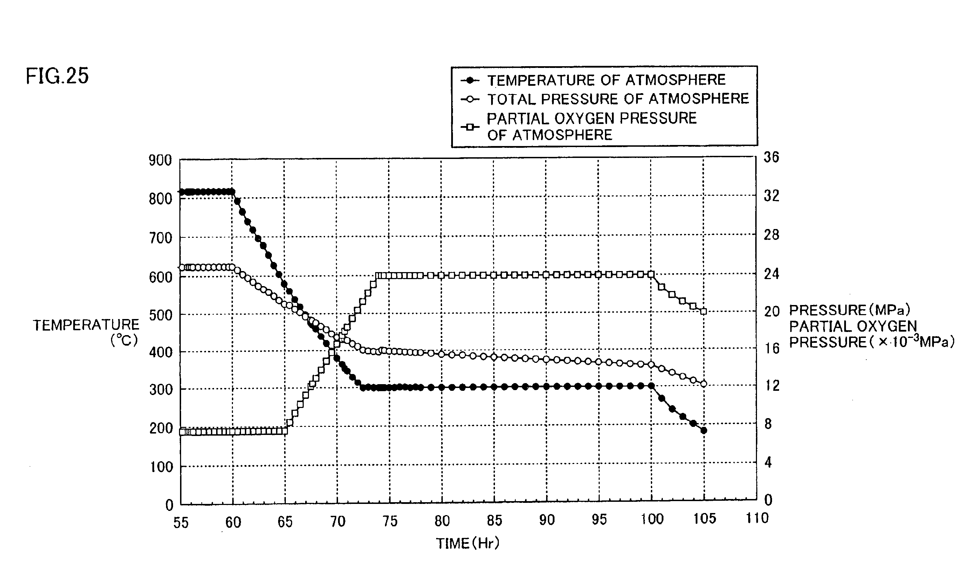

Fig. 25 is a diagram showing exemplary relation between temperatures, total pressures and partial oxygen pressures in a case of performing annealing after heat treatment and time in a seventh embodiment

Referring to Fig. 25, an oxide superconducting wire is held for a constant time in a state where the temperature of the atmosphere is 820°C and the pressure is 25 MPa, and the temperature of the atmosphere is thereafter reduced. At this time, the total pressure of the atmosphere is also slowly reduced. The wire is held at a constant temperature when the temperature and the pressure of the atmosphere reach about 300°C and about 16 MPa respectively, and annealed for about 30 hours. While the wire is held at the constant temperature, the total pressure is further continuously reduced slowly. The temperature of the atmosphere is reduced again after completion of the annealing. The partial oxygen pressure is about 0.008 MPa during the heat treatment, and increased to about 0.024 MPa during the annealing. The partial oxygen pressure is reduced along with the total pressure after the annealing.

In order to confirm the effect of the aforementioned annealing, the inventors have made the following experiment:

They have investigated how much critical current values at 20 K are improved in a case of performing annealing and a case of performing no annealing in heat treatment steps. The annealing was performed with various annealing times and various partial oxygen pressures. Table 3 shows average values of rates of increase of critical current values at 22 K with respect to critical current values at 77 K after heat treatment steps as to respective samples. The critical current values were measured in a magnetic field of 3 T.

[Table 3]

| Sample No. | | Temperature | Time | Partial Oxygen Pressure | Average:Ic(20K) /Ic(77K) |
|---|---|---|---|---|---|
| 1 | unannealed | | | | 1.6 |

(continued)

| Sample No. | | Temperature | Time | Partial Oxygen Pressure | Average:Ic(20K) /Ic(77K) |
|---|---|---|---|---|---|
| 2 | unannealed | | | | 1.7 |
| 3 | unannealed | | | | 1.5 |
| 4 | annealed | 300°C | 30 h | 24kPa | 2.1 |
| 5 | annealed | 300°C | 30 h | 12kPa | 1.9 |
| 6 | annealed | 300°C | 40 | h 20kPa | 2 |

Referring to Table 3, the average values of the rates of increase of the critical current values at 22 K in the case of performing no annealing are 1.6, 1.7 and 1.5 respectively. On the other hand, the average values of the rates of increase of the critical currents at 22 K in the case of performing annealing are 2.1, 1.9 and 2 respectively. Therefore, it is understood that the critical current value at 20 K can be more improved in the case of performing annealing, as compared with the case of performing no annealing. No change of $I_c$ at 77 K was recognized.

In order to confirm the effect of annealing the wire in the atmosphere containing oxygen at the temperature of at least 100°C and not more than 600°C, the inventors have made the following experiment:

First, tape-like Bi-based oxide superconducting wires each having a multifilamentary structure provided with 61 filaments with external sizes of 4.2 mm in width and 0.24 mm in thickness and a silver ratio of 1.5 were prepared. Further, heat treatment was performed on these oxide superconducting wires, and annealing was performed in this heat treatment. The annealing was performed in an oxygen jet for an annealing time of 20 hours at various annealing temperatures shown in Table 4. Further, oxide superconductors were prepared with various quantities of Bi2212 phases $((BiPb)_2Sr_2Ca_1Cu_2O_{8+z}$ superconducting phases). Table 4 also shows critical current values $I_c$ of the respective samples at 77 K and 20 K before and after annealing respectively.

The used wires were selected from the same lot, and it is assumed that superconducting portions of all wires have the same sectional area. Thus, the magnitudes of the critical current values $I_{ec}$ in Table 4 are proportionate to the critical current densities $J_c$ ($J_c = I_c$/sectional area of superconducting portion).

[Table 4]

| Sample No. | Quantity of Bi2212 Phase (%) | Before Annealing 77K Ic(A) | Before Annealing 20K Ic(A)(I) | Annealing Temperature (°C) | After Annealing 77K Ic(A) | After Annealing 20K Ic(A)(2) | (2)/(1) |
|---|---|---|---|---|---|---|---|
| 7 | 9 | 95 | 500 | none | - | - | - |
| 8 | 9 | 95 | 500 | 100 | 95 | 515 | 1.03 |
| 9 | 9 | 95 | 500 | 200 | 95 | 535 | 1.07 |
| 10 | 9 | 95 | 500 | 300 | 94 | 545 | 1.09 |
| 11 | 9 | 95 | 500 | 400 | 92 | 550 | 1.1 |
| 12 | 9 | 95 | 500 | 500 | 90 | 575 | 1.15 |
| 13 | 9 | 95 | 500 | 600 | 89 | 550 | 1.1 |
| 14 | 9 | 95 | 500 | 700 | 70 | 480 | 0.96 |
| 15 | 9 | 95 | 500 | 800 | 60 | 345 | 0.69 |
| 16 | 2 | 100 | 527 | 500 | 99 | 528 | 1.0 |
| 17 | 5 | 97 | 511 | 500 | 96 | 543 | 1.06 |
| 18 | 9 | 95 | 500 | 500 | 90 | 555 | 1.11 |
| 19 | 13 | 92 | 485 | 500 | 88 | 540 | 1.11 |
| 20 | 19 | 90 | 474 | 500 | 82 | 530 | 1.12 |
| 21 | 25 | 83 | 437 | 500 | 75 | 500 | 1.14 |
| 22 | 50 | 60 | 316 | 500 | 50 | 410 | 1.3 |

It is understood from the results in Table 4 that the critical current value $I_c$ (critical current density $J_c$) at a low temperature (20 K) is more improved as compared with that before annealing when the annealing is performed in an oxygen atmosphere at a temperature of at least 100°C and not more than 600°C. Particularly when the annealing temperature is at least 300°C and not more than 600°C and the quantity of the Bi2212 phase in the oxide superconductor is at least 5 mol % and not more than 20 mol %, the critical current value $I_c$ after the annealing is at least 530 A, and it is understood that the absolute value of the critical current value $I_c$ (critical current density $J_c$)is increased.

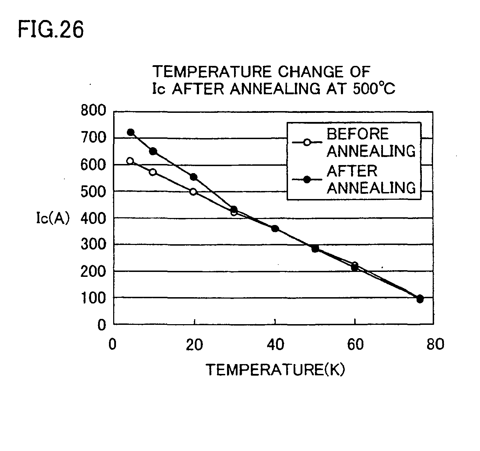

They have also investigated critical current values $I_c$ of oxide superconducting wires at respective temperatures (K) before annealing and after annealing at a temperature of 500°C. Fig. 26 shows the results. It is understood from the results show in Fig. 26 that the critical current values $I_c$ of the annealed samples are higher than those of the samples not yet subjected to annealing from a temperature of not more than about 20 K.

In the method of manufacturing an oxide superconducting wire according to this embodiment, the oxide superconducting wire includes a Bi2223 phase, and the oxide superconducting wire is annealed in an atmosphere containing oxygen at a temperature of at least 100°C and not more than 600°C. Thus, the critical current density of the oxide superconducting wire is improved at a low temperature of about 20 K.

The method of improving the critical current density by performing a prescribed heat treatment method in at least either the first heat treatment (step S4) or the second heat treatment (step S6) shown in Fig. 3 has been shown in this embodiment. However, the present manufacture is also applicable as a heat treatment step performed on the manufactured oxide superconducting wire (i.e., the oxide superconducting wire after completion of the steps S1 to S6 in Fig. 3), i.e., as a method of reforming an oxide superconducting wire, in addition to this case. Also when the heat treatment is employed as a method of reforming an oxide superconducting wire, the critical current density of the oxide superconducting wire can be improved at a low temperature of about 20 K.

The present invention is applicable to a superconducting device such as a superconducting transformer, a superconducting current limiter or a magnetic field generator employing a superconducting magnet composed of an oxide superconducting wire or a superconducting cable, a superconducting bus bar or a superconducting coil employing an oxide superconducting wire, and particularly applicable to a superconducting device in which an oxide superconducting wire is used in a state dipped in a refrigerant. Further, the present invention can effectively suppress ballooning particularly when applied to a superconducting cable among superconducting devices.

The embodiments described in the above must be considered illustrative and not restrictive in all points. The range of the present invention is shown not by the aforementioned embodiments but by the scope of claim for patent.

**Claims**

1. A method of suppressing ballooning of an oxide superconducting wire (1) upon a temperature increase from a state, in which said oxide superconducting wire (1) is disposed below the critical temperature (Tc) in a refrigerant passage (37) of a superconducting cable (30) with a liquid refrigerant being circulated in said refrigerant passage (37), to the ordinary temperature, wherein said temperature increase is executed and for said oxide superconducting wire (1) an oxide superconductor is used, which

    - is a Bi-Pb-Sr-Ca-Cu-O-based oxide superconductor containing bismuth, lead, strontium, calcium and copper and including a Bi2223 phase having atomic ratios of (bismuth and lead): strontium: calcium: copper expressed as 2:2:2:3 in approximation,
    - exhibits a sintering density of at least 93 % to reduce internal gaps in the oxide superconductor and to prevent said liquid refrigerant from infiltrating into said gaps,
    - is obtainable from a manufacturing method comprising covering a raw material powder for the Bi-Pb-Sr-Ca-Cu-O-based oxide superconductor with a metal and
    - has an outer periphery portion formed by rolling said metal.

2. A method according to claim 1, wherein said sintering density is at least 95 %.

3. A method according to claim 2, wherein said sintering density is at least 99 %.

**Patentansprüche**

1. Verfahren zur Vermeidung des Aufblähens eines supraleitenden Oxiddrahts (1) bei einer Temperaturerhöhung von einem Zustand, in dem der supraleitende Oxiddraht (1) unter der kritischen Temperatur (Tc) in einem Kühlabschnitt (37) eines supraleitenden Kabels (30) plaziert ist, wobei ein flüssiges Kühlmittel in dem Kühlbereich (37) zirkuliert, auf Normaltemperatur, wobei die Temperaturerhöhung durchgeführt und für den supraleitenden Oxiddraht (1) ein Oxidsupraleiter verwendet wird, der

- ein Bi-Pb-Sr-Ca-Cu-O-basierter Oxidsupraleiter ist, welcher Bismut, Blei, Strontium, Kalzium und Kupfer enthält und eine Bi2223-Phase aufweist, deren Atomverhältnisse von (Bismut und Blei):Strontium:Kalzium:Kupfer ungefähr 2:2:2:3 betragen,
- eine Sinterdichte von mindestens 93 % aufweist, um Lücken innerhalb des Oxidsupraleiters zu verkleinern und zu vermeiden, daß das flüssige Kühlmittel in die Lücken eindringt,
- mittels eines Herstellungsverfahrens, welches das Beschichten eines Rohstoffpuders für den Bi-Pb-Sr-Ca-Cu-O-basierten Oxidsupraleiter mit einem Metall umfaßt, erhältlich ist und
- einen durch Walzen des Metalls gebildeten äußeren Umfangsbereich aufweist.

2. Verfahren nach Anspruch 1, wobei die Sinterdichte mindestens 95 % beträgt.

3. Verfahren nach Anspruch 2, wobei die Sinterdichte mindestens 99 % beträgt.

**Revendications**

1. Procédé de suppression de ballonnement d'un câble supraconducteur d'oxyde (1) par une augmentation de température à partir d'un état, dans lequel ledit câble supraconducteur d'oxyde (1) est disposé sous la température critique (Tc) dans un passage réfrigérant (37) d'un câble supraconducteur (30) avec un réfrigérant liquide en circulation dans ledit passage réfrigérant (37), jusqu'à la température ambiante, dans lequel ladite augmentation de température est réalisée et pour ledit câble supraconducteur d'oxyde (1) on utilise un supraconducteur d'oxyde, lequel

- est un supraconducteur d'oxyde à base de Bi-Pb-Sr-Ca-Cu-O contenant du bismuth, du plomb, du strontium, du calcium et du cuivre et comprenant une phase Bi2223 présentant des rapports atomiques de (bismuth et plomb) : strontium: calcium : cuivre exprimés comme 2:2:3:3 en approximation,
- présente une densité de frittage d'au moins 93 % pour réduire des espaces internes dans le supraconducteur d'oxyde et pour éviter que ledit réfrigérant liquide ne s'infiltre dans lesdits espaces,
- peut être obtenu à partir d'un procédé de fabrication comprenant la couverture d'une poudre de matière première pour le supraconducteur d'oxyde à base de Bi-Pb-Sr-Ca-Cu-O avec un métal et
- présente une partie périphérique externe formée par laminage dudit métal.

2. Procédé selon la revendication 1, dans lequel ladite densité de frittage est d'au moins 95 %.

3. Procédé selon la revendication 2, dans lequel ladite densité de frittage est d'au moins 99 %.

## FIG.1A

## FIG.1B

## FIG.2

## FIG.3

| |
|---|
| CHARGE RAW MATERIAL POWDER INTO METAL TUBE — S1 |
| WIRE DRAWING — S2 |
| PRIMARY ROLLING — S3 |
| FIRST HEAT TREATMENT — S4 |
| SECONDARY ROLLING — S5 |
| SECOND HEAT TREATMENT — S6 |

OXIDE SUPERCONDUCTING WIRE

## FIG.4

## FIG.5

(a)     (b)     (c)     (d)

FIG.6

NUMBER OF BLISTERS
(NUMBER/10 m)

TOTAL PRESSURE P (MPa)

FIG.7

PRESSURIZED WITH GAS OF THE SAME RATIO ($N_2:O_2= 80:20$)

OXYGEN
PRESSURE
(MPa)

N₂
O₂

TOTAL PRESSURE (MPa)

FIG.8

OXYGEN
PRESSURE
(MPa)

N₂
O₂

$O_2:N_2=$
0.2:0.8    0.1:0.9    0.067:0.933    0.05:0.95    0.04:0.96

TOTAL PRESSURE (MPa)

## FIG.9A

IN HEAT TREATMENT | IN TEMPERATURE REDUCTION

800°C→300°C | 300°C→ROOM TEMPERATURE

TEMPERATURE (°C)

TIME

## FIG.9B

IN HEAT TREATMENT | IN TEMPERATURE REDUCTION

800°C→300°C | 300°C→ROOM TEMPERATURE

TOTAL PRESSURE (MPa)

TIME

FIG.10A

FIG.10B

FIG.11

FIG.12

# FIG.13

```
┌─────────────────────────────┐
│   CHARGE RAW MATERIAL       │── S1
│   POWDER INTO METAL TUBE    │
└─────────────────────────────┘
            ↓
┌─────────────────────────────┐
│       WIRE DRAWING          │── S2
└─────────────────────────────┘
            ↓
┌─────────────────────────────┐
│      PRIMARY ROLLING        │── S3
└─────────────────────────────┘
            ↓
┌─────────────────────────────┐
│      SILVER PLATING         │── S11
└─────────────────────────────┘
            ↓
┌─────────────────────────────┐
│     FIRST HEAT TREATMENT    │── S4
└─────────────────────────────┘
            ↓
┌─────────────────────────────┐
│     SECONDARY ROLLING       │── S5
└─────────────────────────────┘
            ↓
┌─────────────────────────────┐
│      SILVER PLATING         │── S12
└─────────────────────────────┘
            ↓
┌─────────────────────────────┐
│    SECOND HEAT TREATMENT    │── S6
└─────────────────────────────┘
            ↓
   OXIDE SUPERCONDUCTING WIRE
```

FIG.14

FIG.16A

FIG.16B

FIG.16C

FIG.16D

## FIG.17

IN TEMPERATURE INCREASE

IN HEAT TREATMENT

IN TEMPERATURE REDUCTION

TEMPERATURE AND PRESSURE

— TEMPERATURE
— PRESSURE IN ATMOSPHERE
-- INTERNAL PRESSURE OF WIRE

30MPa
830°C
700°C
10MPa

t1   t2   TIME

## FIG.18

○ CONDITION FOR FORMING STABLE OXIDE SUPERCONDUCTING PHASE
⊗ CONDITION FOR HARDLY FORMING STABLE OXIDE SUPERCONDUCTING PHASE

TEMPERATURE (°C)

840
835
830
825
820
815
810
805

0.005   0.007   0.009   0.011

PARTIAL OXYGEN PRESSURE (MPa)

FIG.19

FIG.20

CASE OF PERFORMING HEAT
TREATMENT IN PRESSURIZED
ATMOSPHERE ACCORDING TO
THE PRESENT INVENTION

CASE OF PERFORMING HEAT
TREATMENT IN ATMOSPHERIC
PRESSURE ACCORDING TO
PRIOR ART

CRITICAL
CURRENT
DENSITY

82    86

DRAFT(%)

FIG.21

TEMPERATURE OF ATMOSPHERE
TOTAL PRESSURE OF ATMOSPHERE
PARTIAL OXYGEN PRESSURE
OF ATMOSPHERE

FIG.22

FIG.23

EP 1 667 173 B1

# FIG.24

EP 1 667 173 B1

FIG.25

FIG.26

TEMPERATURE CHANGE OF
Ic AFTER ANNEALING AT 500°C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002260458 A
- EP 1659595 A1

- EP 1096580 A1

**Non-patent literature cited in the description**

- **Y. YUAN et al.** Microstructure and Jc Improvements in Overpressure Processed Ag-Sheathed Bi-2223 Tapes. *IEEE Transactions on applied superconductivity,* June 2003, vol. 13 (2), 2921-2925